# EUROPEAN PATENT APPLICATION

(11) **EP 2 023 379 A1**
(43) Date of publication of application: **11.02.2009**
(21) Application number: 07743152.6
(22) Date of filing: 11.05.2007
(51) Int. Cl.: H01L 21/027, G03F 7/20

(54) **EXPOSURE APPARATUS AND EXPOSURE METHOD**

(30) Priority: 31.05.2006 JP 2006151208
(71) Applicant: Nikon Corporation, Tokyo 100-8331 (JP)
(72) Inventor: OKITA, Shinichi, Tokyo 100-8331 (JP)
(74) Representative: Hooiveld, Arjen Jan Winfried
(86) International application number: PCT/JP2007/059717
(87) International publication number: WO 2007/138834

(57) **Abstract**

An exposure apparatus illuminates a pattern on a first object (M) with an illuminating beam (EL) to expose an area to be exposed on a second object (P) with a pattern image. The exposure apparatus includes a scanning apparatus (22) that scans the first object in a prescribed scanning direction with the illuminating beam, and an optical guiding device (DK) that guides the illuminating beam which has scanned the first object onto the area to be exposed on the second object.

## Description

### TECHNICAL FIELD

The present invention relates to an exposure apparatus and an exposure method for exposing a pattern formed on a mask and transferring the pattern onto a substrate.

The present application claims priority on Japanese Patent Application No. 2006-151208 filed on May 3 1 st, 2006, the contents of which are incorporated herein by reference.

### BACKGROUND ART

In manufacturing microdevices such as semiconductor devices, liquid crystal display devices, image pick-up devices (charge coupled devices (CCD) and the like), and thin-film magnetic heads, an exposure apparatus is used, which transfers a pattern formed on a mask or a reticle (hereinafter, generically termed a mask) onto a wafer or a glass plate (hereinafter, generically termed a substrate) applied with a photosensitive material such as a photoresist. Recently, a step and repeat type reduced size projection exposure apparatus (a so-called stepper) or a step and scan type exposure apparatus (a so-called scanning stepper) has been used frequently.

The stepper is an exposure apparatus in which a substrate is placed on a substrate stage which is movable two-dimensionally, and the substrate is stepped by the substrate stage, to expose an image of a pattern of a mask in a reduced size in one shot onto each shot field on the substrate, and this process is sequentially repeated. The scanning stepper is an exposure apparatus in which a part of a pattern formed on a mask is sequentially transferred onto a shot field on the substrate, while a mask stage on which the mask is placed and a substrate stage on which the substrate is placed are synchronously moved (scanned), in a state with pulses of exposure light in a long and narrow rectangular shape (in a slit form) being irradiated onto the mask. With this exposure apparatus, when transfer of the pattern with respect to one shot field has finished, the substrate is stepped in a direction orthogonal to a scanning direction to transfer the pattern into another shot field.

In the aforementioned scanning stepper, every time exposure for one shot field finishes, the scanning directions of the mask stage and the substrate stage are reversed to perform exposure processing sequentially. That is, plus scan and minus scan are alternately repeated for each shot field. Therefore, in the scanning stepper, acceleration and deceleration of the mask stage and the substrate stage are performed every time the shot field is exposed.

Here, to improve exposure accuracy, it is desired to start the exposure processing after vibration that occurs after completion of acceleration is settled, and both stages are at constant speed and sufficient synchronization can be achieved. For this purpose, a certain settling time (the time required until vibrations of respective stages are settled and the speed becomes constant after acceleration is finished) needs to be ensured. However, in the scanning stepper, since acceleration and deceleration are repeated, if the settling time becomes long, it directly leads to a reduction in throughput (the number of wafers that can be processed in unit time). Therefore, it has not been easy to improve both the exposure accuracy and the throughput in the scanning stepper. Recently, because there is a tendency for the substrate to have large dimensions in order to improve producibility and reduce production cost of the devices, it is desired to decrease the number of accelerations and decelerations of the stages.

In the following Patent Document 1 is disclosed an exposure apparatus that uses a reticle having a plurality of patterns formed thereon, which are to be transferred onto shot fields different from each other, to perform exposure for a plurality of shot fields by one scanning by synchronously moving the reticle in an arrangement direction of the pattern. In such an exposure apparatus, the number of accelerations and decelerations of the stages can be reduced to a fraction of the patterns formed on the reticle (for example, 1/2 when two patterns are formed). Therefore, deterioration in synchronization accuracy resulting from acceleration and deceleration of the stages can be reduced, and the throughput can be improved.

Moreover, in the following Patent Document 2 is disclosed an exposure method in which a first and a second reticle stage are provided, the second reticle stage is moved in an opposite direction while the first reticle stage is being scanned, and after completion of scanning of the first reticle stage, exposure by using the second reticle stage is performed, synchronously with continuous movement of the wafer stage. According to such an exposure method, exposure to the shot fields for one line of the shot fields set on the wafer can be performed without acceleration and deceleration of the wafer stage.
[Patent Document 1] Japanese Patent Application Publication No. H10-284411 A
[Patent Document 2] Japanese Patent No. 3531297

### DISCLOSURE OF INVENTION

### [Problems to be Solved by the Invention]

In Patent Document 1, in order to reduce the number of accelerations and decelerations of the stages, many patterns need to be formed on the reticle. Therefore, the reticle has large dimensions, thereby increasing the cost required for production of the reticle. Moreover, since a large-dimension reticle is used, the size of the reticle stage increases, thereby causing a problem of cost increase of the exposure apparatus.

The size of the reticle becomes larger than the size of the wafer (for example, 4 to 5 times) since a reduced size projection optical system is frequently used, and in the reticle stage for moving the reticle, the movement stroke increases. Therefore, a stator of a linear motor for driving the reticle stage becomes large, increasing the weight of the reticle stage or increasing the heat output involved with driving of the stage, thereby causing a problem in that factors that decrease positioning accuracy such as air fluctuations increase.

In Patent Document 2, it is necessary to provide a plurality of reticle stages and form reticles to be placed on the respective reticle stages. Furthermore an optical system for projecting an image of a reticle pattern placed on the respective reticle stages onto a wafer needs to be provided. Moreover, it is of course necessary to achieve synchronization between respective reticle stages, and further, synchronization between these reticle stages and the wafer stages needs to be achieved. Therefore, there are problems in that the cost of the exposure apparatus considerably increases, and the cost for manufacturing the reticles is doubled.

A purpose of the present invention is to provide an exposure apparatus and an exposure method that can reduce the weight of the reticle stage.

Another purpose of the present invention is to provide an exposure apparatus and an exposure method that can reduce the number of accelerations and decelerations of the stage without causing a considerable rise in the cost, and as a result, can improve the exposure accuracy.

### [Means for Solving the Problem]

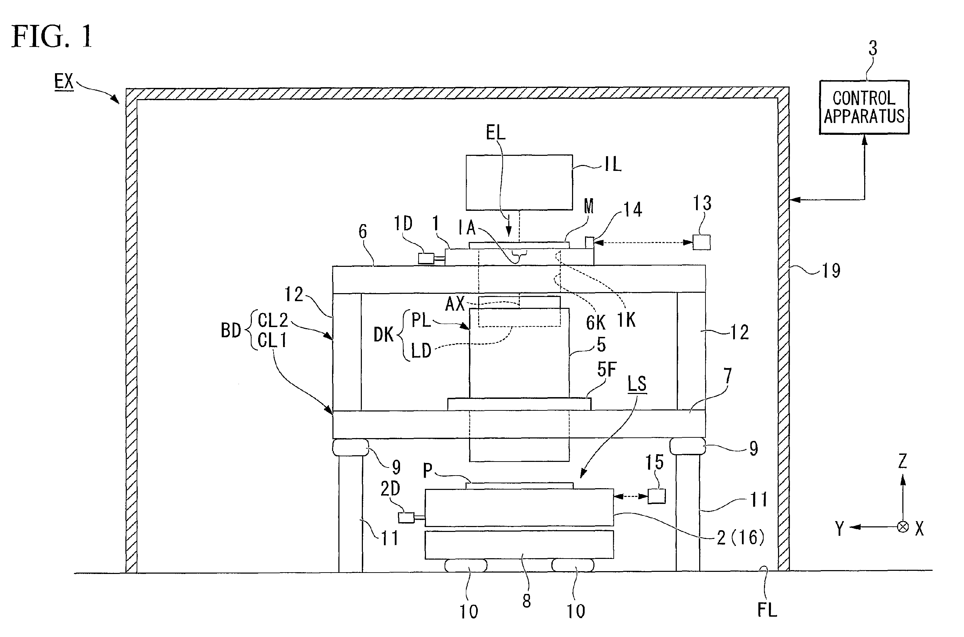

The present invention adopts the following configuration associated with FIGS. 1 to 23 showing embodiments.

According to a first aspect of the present invention, there is provided an exposure apparatus (EX) that illuminates a pattern on a first object (M) with an illuminating beam (EL) to expose an area to be exposed (SA1 to SAn) on a second object (P) with a pattern image, wherein the exposure apparatus comprises; a scanning apparatus (22) that scans the first object (M) in a prescribed scanning direction with the illuminating beam (EL), and an optical guiding device (DK) that guides the illuminating beam (EL) which has scanned the first object (M) onto the area to be exposed (SA1 to SAn) on the second object (P).

According to a second aspect of the present invention, there is provided an exposure method for illuminating a pattern on a first object (M) with an illuminating beam (EL) to expose an area to be exposed (SA1 to SAn) on a second object (P) with a pattern image, wherein the exposure method comprises; a scanning step for scanning the first object (M) in a prescribed scanning direction with the illuminating beam (EL), and an optical guiding step for guiding the illuminating beam (EL) which has scanned the first object (M) onto the area to be exposed (SA1 to SAn) on the second object (P).

According to the first or second aspects, the first object (M) such as a mask does not move with respect to the illuminating beam (EL), but the illuminating beam (EL) is moved to scan the first object (M) in the prescribed scanning direction, and is guided onto the area to be exposed (SA1 to SAn) on the second object (P). Therefore, the first object (M) need not be driven. Accordingly, a drive apparatus having a large movement stroke need not be installed, thereby enabling a reduction in the weight of the stage.

According to a third aspect of the present invention, there is provided an exposure apparatus (EX) that illuminates a pattern formed on a first object (M) with an illuminating beam (EL) to expose an area to be exposed (SA1 to SAn) on a second object (P) with a pattern image, wherein the exposure apparatus comprises; a scanning apparatus (22) that scans the first object (M) with the illuminating beam (EL), and a stage device (2) capable of placing a second object (P) thereon, which moves the second object (P) synchronously with the scan of the first object (M) with the illuminating beam (EL).

According to a fourth aspect of the present invention, there is provided an exposure method for illuminating a pattern formed on a first object (M) with an illuminating beam (EL) to expose an area to be exposed (SA1 to SAn) on a second object (P) with a pattern image, wherein the exposure method comprises a scanning step for scanning the first object (M) with the illuminating beam (EL), and a moving step for moving a stage device (2) capable of placing a second object (P) thereon, synchronously with the scan of the first object (M) with the illuminating beam (EL).

According to the third or fourth aspects, since the first object (M) such as a mask does not move with respect to the illuminating beam (EL), but the illuminating beam (EL) is moved to scan the first object (M) in the prescribed scanning direction, the stage device (2) need not be driven with a large stroke. Accordingly, a drive apparatus having a large movement stroke need not be installed, thereby enabling a reduction in the weight of the stage.

According to a fifth aspect of the present invention, there is provided an exposure apparatus (EX) that illuminates a pattern formed on a first object (M) with an illuminating beam (EL) to expose an area to be exposed on a second object (P) with a pattern image, wherein the exposure apparatus comprises: a scanning apparatus (22) that scans the first object (M) in a prescribed scanning direction with the illuminating beam (EL); an optical guiding device (DK) that guides the illuminating beam (EL) that has scanned the first object (M) onto the second object (P); and a stage device (2) capable of placing a second object (P) thereon, which moves the second object (P) synchronously with the scan of the first object (M) with the illuminating beam (EL).

According to a sixth aspect of the present invention, there is provided an exposure method for illuminating a pattern formed on a first object (M) with an illuminating beam (EL) to expose an area to be exposed (SA1 to SAn) on a second object (P) with a pattern image, wherein the exposure method comprises a scanning step for scanning the first object (M) with the illuminating beam (EL), an optical guiding step for guiding the illuminating beam (EL) onto the second object (P), and a moving step for moving a stage device (2) capable of placing a second object (P) thereon, synchronously with the scan of the first object (M) with the illuminating beam (EL).

According to the fifth or sixth aspects, since the first object (M) such as a mask does not move with respect to the illuminating beam (EL), but the illuminating beam (EL) is moved to scan the first object (M) in the prescribed scanning direction, and is guided onto the area to be exposed (SA1 to SAn) on the second object (P), the stage device (2) need not be driven with a large stroke. Accordingly, a drive apparatus having a large movement stroke need not be installed, thereby enabling a reduction in the weight of the stage.

In order to facilitate explanation of the present invention, explanation is given in association with reference symbols in the drawing indicating embodiment. Needless to say, however, the present invention is not limited to the embodiment.

### [Effect of the Invention]

According to the aspects of the present invention, the apparatus can be made small and light, and can improve the exposure accuracy, without causing a considerable cost increase.

### BRIEF DESCRIPTION OF THE DRAWINGS

FIG. 1 is a schematic block diagram showing an exposure apparatus according to a first embodiment.
FIG. 2 is an outline perspective view showing a schematic configuration of the exposure apparatus.
FIG. 3 is a flow chart showing a method for transferring a pattern of a mask onto a substrate.
FIG. 4 shows one example of a plan view of the substrate.
FIG. 5 shows an operation at the time of exposure processing.
FIG 6 is a schematic block diagram showing an exposure apparatus according to a second embodiment.
FIG. 7 is an outline perspective view showing a schematic configuration of an exposure apparatus according to a third embodiment.
FIG 8 is an outline perspective view showing a schematic configuration of an exposure apparatus according to a fourth embodiment.
FIG 9 shows an operation at the time of exposure processing.
FIG 10 is an outline perspective view showing a schematic configuration of an exposure apparatus according to a fifth embodiment.
FIG 11 shows an operation at the time of exposure processing.
FIG 12A shows an operation at the time of exposure processing.
FIG. 12B shows an operation at the time of exposure processing.
FIG. 12C shows an operation at the time of exposure processing.
FIG. 13 is an outline perspective view showing a schematic configuration of an exposure apparatus according to a sixth embodiment.
FIG 14 shows a modified example of the exposure apparatus shown in FIG. 13.
FIG 15 is an outline perspective view showing a schematic configuration of an exposure apparatus according to a seventh embodiment.
FIG 16 shows an operation at the time of exposure processing.
FIG 17 shows an operation at the time of exposure processing.
FIG 18A shows a pattern example arranged on a mask.
FIG 18B shows a pattern example arranged on the mask.
FIG 18C shows a pattern example arranged on the mask.
FIG 18D shows a pattern example arranged on the mask.
FIG 19 is an outline perspective view showing a schematic configuration of an exposure apparatus according to an eighth embodiment.
FIG 20 is a side view showing a configuration of a projection optical system included in the exposure apparatus according to the eighth embodiment of the present invention.
FIG. 21 is an outline perspective view showing a schematic configuration of an exposure apparatus according to a ninth embodiment.
FIG. 22 is a flow chart showing one example of a process for fabricating microdevices.
FIG. 23 shows one example of a detailed process in step S 13 in FIG 22.

### [Brief Description of the Reference Symbols]

EL : Exposure light (illuminating beam, slit light), EL': Exposure light (second illuminating beam, slit light), EX : Exposure apparatus, E1 : Position (first position), E2 : Position (second position), DK : Optical guiding device, DK' : Second optical guiding device, LD, LD' : Conduction apparatus, M : Mask (first object, reticle), M' : Mask (third object, reticle), P : substrate (second object), PL: Projection optical system, SA1 to SAn : Shot fields (areas to be exposed), 2 : Substrate stage (stage device), 3 : Control apparatus (direction switching device, adjusting device), 22 : Polygon mirror (scanning device), 22a : Reflecting surface (third reflecting surface), 22e : Reflecting surface (fourth reflecting surface), 22' : Polygon mirror (second scanning device), 30, 30' : Reflecting mirror (movable reflecting member), 32 : Reflecting mirror (second movable reflecting member), 33a : Reflecting surface (first reflecting surface), 33b : Reflecting surface (second reflecting surface), 40, 40' : Correction optical system (compensator), 70 : Concentrating optical system (concentrating device), 71, 72 : Trapezoidal optical member (displacement member), 122 : Polygon mirror (second polygon mirror).

### BEST MODE FOR CARRYING OUT THE INVENTION

Hereunder is a description of embodiments of the present invention, with reference to the drawings. However the present invention is not limited thereto. In the following description, an XYZ rectangular co-ordinate system is established, and the positional relationship of respective members will be described with reference to this XYZ rectangular co-ordinate system. A predetermined direction within a horizontal plane is made the X axis direction, a direction orthogonal to the X axis direction in the horizontal plane is made the Y axis direction, and a direction orthogonal to both the X axis direction and the Y axis direction (that is, a perpendicular direction) is made the Z axis direction. Furthermore, rotation (inclination) directions about the X axis, the Y axis and the Z axis are made the θX, the θY, and the θZ directions respectively.

### <First Embodiment>

A first embodiment will be described. FIG. 1 is a schematic block diagram showing an exposure apparatus EX according to the first embodiment. In FIG 1, the exposure apparatus EX includes; a mask stage 1 that is capable of holding and moving a mask M as a first object, a substrate stage (stage device) 2 that is capable of holding and moving a substrate P as a second object, an illumination system IL that illuminates a pattern of the mask M with exposure light (illuminating beam) EL, an optical guiding device DK that guides the exposure light EL illuminating the mask M to a shot field (area to be exposed) on the substrate P, and a control apparatus 3 that controls the operation of the overall exposure apparatus EX. The optical guiding device DK includes a projection optical system PL that projects an image of the pattern of the mask M illuminated by the exposure light EL onto the substrate P, and a conduction apparatus LD that causes the exposure light EL illuminating the mask M to enter into the projection optical system PL (details thereof will be described later).

Moreover, the exposure apparatus EX includes a chamber device 19 that houses at least the projection optical system PL. In the first embodiment, at least the mask stage 1, the substrate stage 2, the illumination system IL, the projection optical system PL, and the optical guiding device DK are housed in the chamber device 19.

Substrate here includes one in which a photosensitive material (photoresist) is spread on a substrate such as a semiconductor wafer such as a silicon wafer, and one in which various films such as a protective coat (top coat) are applied separately from a photosensitive film. The mask includes a reticle on which is formed a device pattern to be projected in a reduced size onto the substrate. The mask is one where a predetermined pattern is formed using a light shielding membrane such as chrome or the like on a transparent member of for example a glass plate. Furthermore, in the present embodiment, a transmission type mask is used for the mask, however a reflection type mask may be used. The transmission type mask is not limited to a binary mask in which the pattern is formed by the light shielding membrane, and includes a phase shift mask such as a half tone type or a spatial frequency modulation type.

Moreover the exposure apparatus EX of the present embodiment is a scanning type exposure apparatus (a so-called scanning stepper) that scans exposure light EL in a predetermined scanning direction with respect to the pattern region of the mask M, and moves the substrate P simultaneously with the scan of the exposure light EL to project the image of the pattern of the mask M onto the substrate P. In the present embodiment, the scanning direction of the substrate P is the Y axis direction, and the scanning direction (the simultaneous moving direction) of the mask M is also the Y axis direction. That is, the exposure apparatus EX, while moving the shot field on the substrate P in the Y axis direction with respect to the projection field AR of the projection optical system PL, and also moving the illumination field IA of the illumination system IL in the Y axis direction with respect to a pattern forming field of the mask M synchronously with movement of the substrate P in the Y axis direction, irradiates the exposure light EL onto the projection field AR via the projection optical system PL, to thereby expose the shot field on the substrate P with the image of the pattern formed on the projection field AR. Detailed configuration of the illumination system IL will be described later.

The exposure apparatus EX includes a body BD including a first column CL1 provided on a floor FL in, for example, a clean room, and a second column CL2 provided on the first column CL1. The first column CL1 includes a plurality of first supports 11 and a lens-barrel base 7 supported via an antivibration device 9 on those first supports 11. The second column CL2 includes a plurality of second supports 12 provided on the lens-barrel base 7, and a mask stage base 6 supported via an antivibration device 4 on those second supports 12.

The mask stage 1 is movable by drive of a mask stage drive device 1D which includes an actuator such as a linear motor, on the mask stage base 6, in the X axis, the Y axis, and the θZ directions in a condition with the first mask M held. However, since a movement amount in the respective directions is very small such as only for aligning the mask M, a driven amount of the mask stage drive device is also controlled in a very small amount.

The mask stage 1 has a first opening 1K for allowing the exposure light EL to pass therethrough at the time of exposure of the substrate P. The mask stage base 6 has a second opening 6K for allowing the exposure light EL to pass therethrough. These first and second openings 1K and 6K are formed in a size in which the exposure light EL that scans the pattern forming field on the mask M can pass therethrough without any problem.

The exposure light EL emitted from the illumination system IL and having irradiated the pattern forming field on the mask M, enters into the projection optical system PL after passing through the first opening 1K of the mask stage 1 and the second opening 6K of the mask stage base 6.

Position information of the mask stage 1 (and in turn the mask M) is measured by a laser interferometer 13. The laser interferometer 13 measures the position information of the mask stage 1 using a reflecting surface 14 of a moving mirror provided on the mask stage 1. The control apparatus 3 drives the mask stage drive device 1D based on the measurement result of the laser interferometer 13, to perform position control of the mask M which is held on the mask stage 1.

The projection optical system PL projects an image of the pattern of the mask M onto the substrate P at a predetermined projection magnification, and includes a plurality of optical elements. These optical elements are held by a lens barrel 5. The lens barrel 5 has a flange 5F, and the projection optical system PL is supported on the lens-barrel base 7 via the flange 5F. The antivibration device can be provided between the lens-barrel base 7 and the lens barrel 5. In the projection optical system PL of the present embodiment, the projection magnification is for example a reduction system of for example 1/4, 1/5, or 1/8, and forms a reduced image of the pattern in the exposure field on the substrate. The projection optical system PL can be any one of the reduction system, an equal magnification system, or an enlarging system. Furthermore, the projection optical system PL may be a refractive system which does not include a reflecting optical element, a reflecting system which does not include a refractive optical element, or a reflection / refraction system which includes a reflecting optical element and a refractive optical element. Furthermore, the projection optical system PL can form any one of an inverted image or an erect image (in the embodiment, a configuration forming the inverted image is adopted).

The substrate stage 2 holds the substrate P, and it is movable by drive of a substrate stage drive device 2D including an actuator such as a linear motor, in directions of 6 degrees of freedom of the X axis, the Y axis, the Z axis, the θX, the θY, and the θZ directions, on a substrate stage base 8 in a condition with the substrate P held. The substrate stage 2 is supported without contact on the upper surface (guide surface) of the substrate stage base 8, by an air bearing. The substrate stage base 8 is supported on the floor FL via an antivibration device 10. The position information of the substrate stage 2 (and in turn the substrate P) is measured by a laser interferometer 15. The laser interferometer 15 measures the position information related to the X axis, the Y axis, and the θZ directions of the substrate stage 2 using a reflecting surface 2 which is provided on the substrate stage 2. The exposure apparatus EX includes a focus leveling system (not shown in the figure) capable of detecting the surface information (position information related to the Z axis, the θX, and the θY directions) of the surface of the substrate P held on the substrate stage 2. The control apparatus 3 drives the substrate stage drive device 2D based on the measurement result of the laser interferometer 15, and the detection result of the focus leveling detection system, and performs position control of the substrate P held in the substrate stage 2.

As disclosed for example in U.S. Patent No.6,608,681, the focus leveling detection system measures the position information of the substrate P in the Z axis direction at a plurality of measurement points, respectively, to thereby detect the surface information of the substrate P. The laser interferometer 15 may be able to measure the position information of the substrate stage 2 in the Z axis, the θX and the θY directions, and details thereof are disclosed for example in Published Japanese translation No. 2001-510577 of PCT International Publication (corresponding to PCT International Patent Publication No.1999/28790).

The illumination system IL illuminates a predetermined illumination field IA on the mask M, with slit exposure light EL of a uniform luminance distribution. For the exposure light EL emitted from the illumination system IL, for example emission lines (g-ray, h-ray, i-ray), emitted for example from a mercury lamp, deep ultraviolet beams (DUV light beams) such as the KrF excimer laser beam (wavelength: 248nm), and vacuum ultraviolet light beams (VUV light beams) such as the ArF excimer laser beam (wavelength: 193nm) and the F₂ laser beam (wavelength: 157nm), may be used. In this embodiment, the ArF excimer laser beam is used.

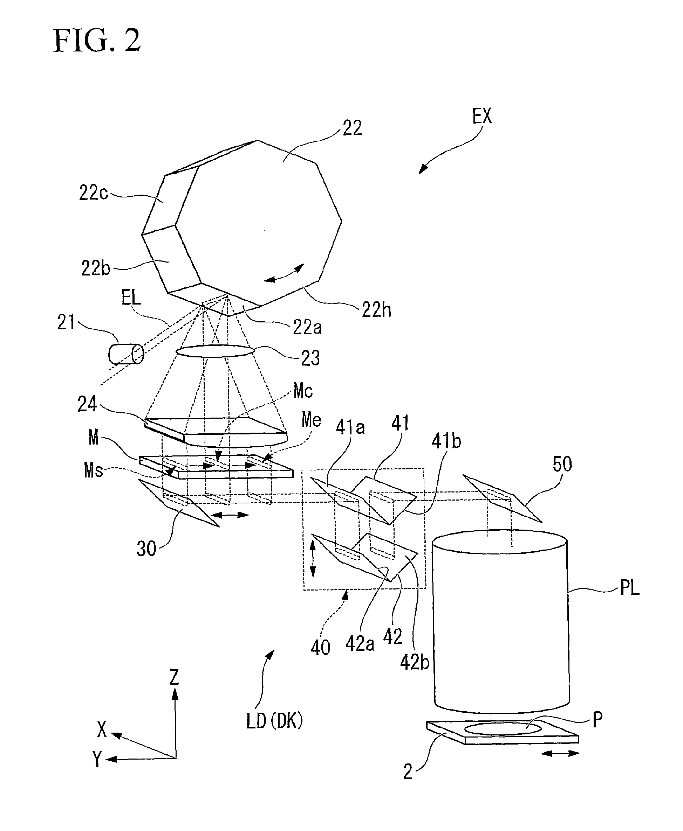

Moreover as shown in FIG 2, the illumination system IL is provided with; a polygon mirror that rotates about the X axis and reflects a slit-shape laser beam serving as the exposure light EL irradiated via a correcting lens 21, toward the mask M, an fθ lens 23 that makes an image height proportionate to an incident angle (scanning angle), and a telecentric lens 24 that converts the exposure light EL transmitted through the fθ lens 23 into telecentric light (light parallel to Z axis).

The polygon mirror 22 has a plurality of reflecting surfaces 22a to 22h (eight surfaces in FIG 2) on the circumference thereof, and rotation is controlled by the control apparatus 3.

The conduction apparatus LD includes; a reflecting mirror 3 0 provided on -Z side of the mask M to bend the exposure light EL toward -Y direction transmitted through the mask M, a correction optical system 40 that corrects differences in optical path lengths of the exposure light EL, and a reflecting mirror 50 that bends the exposure light EL having passed through the correction optical system 40 to make the exposure light EL enter into the projection optical system PL.

The reflecting mirror 30 moves in the Y axis direction synchronously with the rotation of the polygon mirror 22 under control of the control apparatus 3.

The correction optical system 40 has reflecting mirrors 41 and 42 having a right-angled intersection angle and substantially V shape as seen from the front. The respective reflecting mirrors 41 and 42 have reflecting surfaces 41 a and 41b, and reflecting surfaces 42a and 42b that bend the exposure light EL entering into positions facing each other by 90 degrees. The slit-shape exposure light EL reflected by the reflecting mirror 30 is sequentially reflected by the reflecting surface 41a of the reflecting mirror 41, the reflecting surfaces 42a and 42b of the reflecting mirror 42, and the reflecting surface 41b of the reflecting mirror 41 to enter onto the reflecting mirror 50. The reflecting mirror 42 moves in the Z axis direction, so as to be freely movable toward and away from the reflecting mirror 41 under the control of the control apparatus 3.

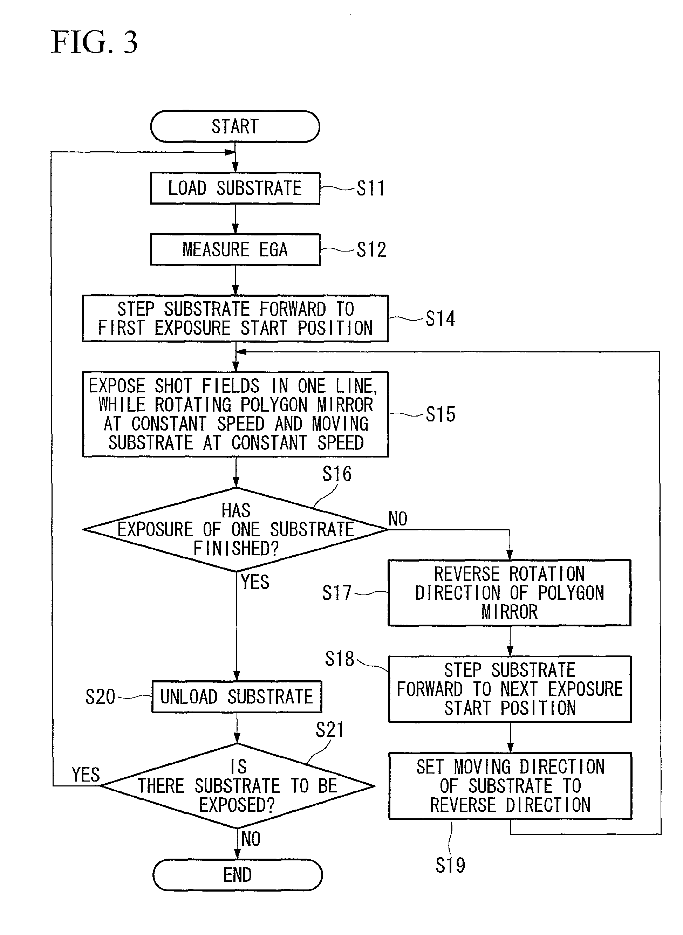

Next is a description of an exposure method for transferring the pattern of the mask M onto the substrate P using the exposure apparatus EX, with reference to the flow chart shown in FIG. 3.

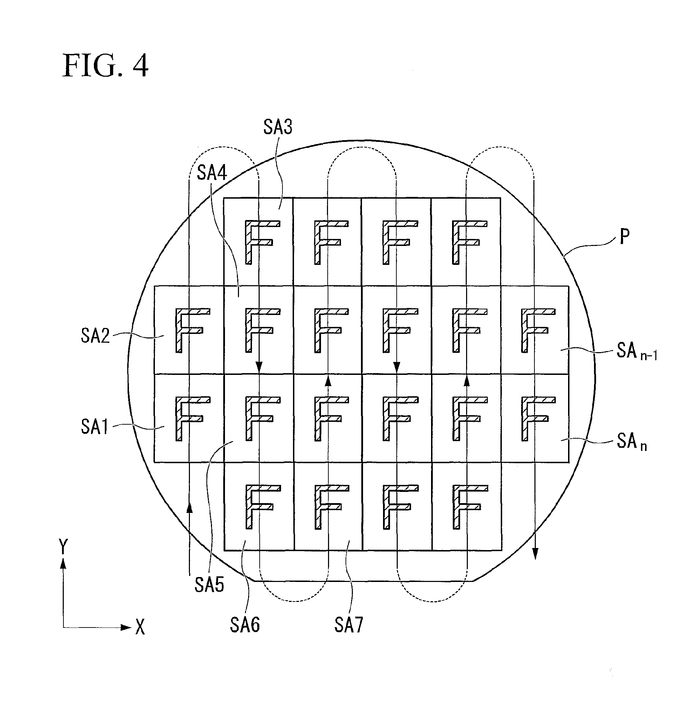

For simplifying the explanation, it is assumed that the pattern of a character "F" to be transferred onto the substrate P in the pattern forming field of the mask (see FIG 4) is formed by patterning a metal film made of, for example, chromium (Cr) in a predetermined shape.

FIG. 3 is a flow chart showing the exposure method according to the first embodiment of the present invention.

When an exposure sequence is started, the substrate P is loaded on the substrate stage 2 (step S11). While the substrate P is being loaded, replacement of the mask M is also performed as required.

Next an enhancement global alignment (EGA) measurement is performed (step S 12). Here the EGA measurement is an arithmetic method, in which the regularity of arrangement of all the shot fields set on the substrate P is determined by a statistical method based on position information and design information of a mark (alignment mark) formed in association with a part of (3 to 9) representative shot fields preset on the substrate P. Specifically, the position information of several representative marks formed on the substrate P loaded on the substrate stage 2 is measured by using an alignment sensor. A main control system MC performs the EGA operation based on the measurement result to determine the regularity of the arrangement of all the shot fields set on the substrate P.

Subsequently, the control apparatus 3 drives the substrate stage 2 to cause the substrate P to step forward to a first exposure start position (step S 14). The substrate P as the body to be exposed is explained here. FIG. 4 is a plan view of one example of the substrate P. As shown in FIG 4, a plurality of shot fields (areas to be exposed) SA1 to SAn ("n" is a natural number not less than 2) is arranged on the substrate P in the X and Y directions. In FIG. 4, for simplifying the explanation, the maximum number of the shot fields in the Y direction (scanning direction) is set to 4. When the substrate P is exposed, it is assumed that exposure is performed from a shot field SA1 to a shot field SAn shown in FIG 4 sequentially. Therefore, in step S 14, the substrate stage 2 is driven so that the shot field SA1 is arranged close to the +Y side of the projection field of the projection optical system PL (exposure operation start position).

When the movement of the substrate P to the exposure operation start position is famished, the control apparatus 3 outputs a control signal to the substrate stage 2 to start acceleration in the -Y direction, and outputs a control signal to a rotating device (not shown in the figure) of the polygon mirror 22 to start rotation of the polygon mirror 22 in the X axis direction (here, in FIG 2, the counterclockwise direction). The control apparatus 3 moves the reflecting mirror 30 in the -Y direction synchronously with the rotation of the polygon mirror 22.

The rotation operation of the polygon mirror 22 can be started at a point in time before step S 14 (for example, in parallel with the EGA measurement in step S12).

The slit-shape exposure light reflected by the reflecting surface 22a of the polygon mirror 22 (illumination beams) EL (hereinafter, appropriately referred to as slit light EL) is transmitted through the fθ lens 23 and the telecentric lens 24 to telecentrically illuminate the pattern field of the mask M. At this time, since the polygon mirror 22 rotates at a constant speed (uniform speed), the position of the slit light EL that illuminates the mask M moves in the -Y direction at the constant speed. As a result, the whole area of the pattern field of the mask M is scanned by the slit light EL. The control apparatus 3 drives the reflecting mirror 30 and the reflecting mirror 42 of the correction optical system 40 synchronously with the scan of the mask M by the slit EL.

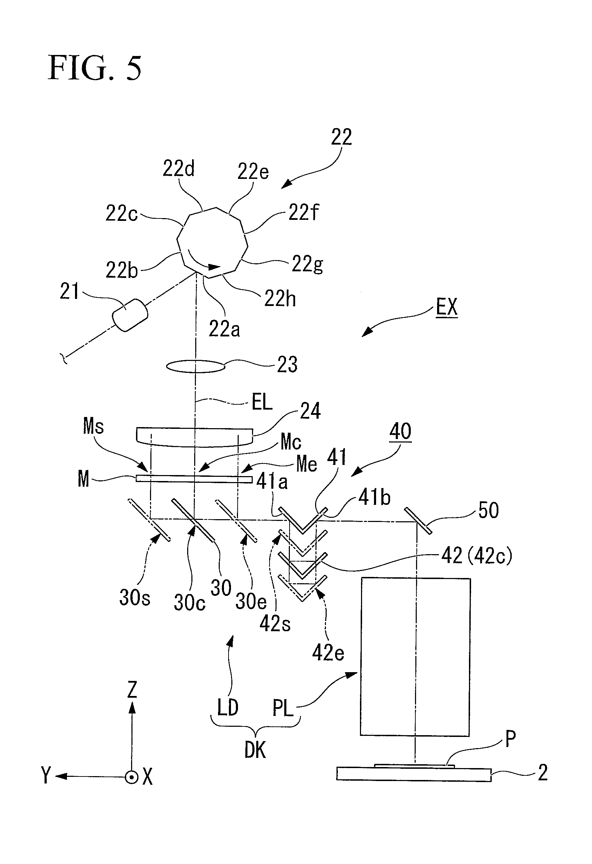

Hereunder, an operation of the reflecting mirror 30 and the reflecting mirror 42 of the correction optical system 40 associated with the scan of the mask M by the slit light EL is explained with reference to FIG 5.

Here, the positions of the reflecting mirror 30 and the reflecting mirror 42 of the correction optical system 40 corresponding to a scanning start position (here, the position at which the pattern field of the mask M actually starts to be projected on the substrate P after completion of an acceleration process or a settling process of the substrate stage 2, is referred to as the scanning start position (same as the scanning end position)) at the time of scanning the pattern field of the mask M from left to right in FIGS. 2 and 5 at the constant speed (uniform speed) are expressed with subscript s. The positions of the reflecting mirror 30 and the reflecting mirror 42 of the correction optical system 40 corresponding to the scanning end position are expressed with subscript e. The positions of the reflecting mirror 30 and the reflecting mirror 42 of the correction optical system 40 corresponding to the center of the mask are expressed with subscript c.

When the slit light EL is at a scanning start position Ms with respect to the pattern field of the mask M, the reflecting mirror 30 is at a position 30s to reflect the slit light EL on the optical path of the slit light EL so as to enter onto the reflecting surface 41a of the reflecting mirror 41. The slit light EL moves from a reflecting position 30s to a scanning end position 30e via a reflecting position 30c with the uniform speed, as the position for illuminating the pattern field of the mask M moves from a scanning start position Ms to a scanning end position Me via the center of the mask Mc (synchronously with the movement thereof). Due to the movement of the reflecting mirror 30 synchronously with the scan of the slit light EL, the slit light EL always enters onto the reflecting surface 41a of the reflecting mirror 41.

Since the optical path length of the slit light EL fluctuates with the synchronous movement of the reflecting mirror 30, the reflecting mirror 42 moves in the Z axis direction so that the optical path length becomes constant by correcting the fluctuation portion. Specifically, when the reflecting mirror 30 is at the position 30s (when the slit light EL illuminates the scanning start position Ms), the optical path length of the slit light becomes large. On the other hand, when the reflecting mirror 30 is at the position 30e (when the slit light EL illuminates the scanning end position Me), the optical path length of the slit light becomes small.

Therefore, in order to realize a reference length, designating the optical path length of the slit light EL when the slit light EL illuminates the mask center Mc and the reflecting mirror 30 is at the central position 30c as a reference, a central position of the reflecting mirror 42 is designated as a reference position 42c of reciprocal movement thereof with respect to the reflecting mirror 41 in the Z axis direction. The reflecting mirror 42 reciprocates at the uniform speed between a position 42s where the reflecting mirror 42 approaches the reflecting mirror 41 closest so that the distance between the reflecting mirrors 41 and 42 becomes shortest, when the optical path length of the slit light EL is maximum at the position 30s where the slit light EL illuminates the scanning start position Ms and the reflecting mirror 30 is farthest from the reflecting mirror 41, and a position 42e where the reflecting mirror 42 is farthest from the reflecting mirror 41 and the distance between the reflecting mirrors 41 and 42 becomes longest, when the optical path length of the slit light EL is minimum at a position 30e where the slit light EL illuminates the scanning end position Me and the reflecting mirror 30 is closest to the reflecting mirror 41. Accordingly, the slit light EL enters into the projection optical system PL via the reflecting mirror 50 at a constant optical path length at all times even when the position for illuminating the mask M moves, and the pattern image of the mask M is sequentially projected onto the shot field SA1 on the substrate P shown in FIG 4.

When the scanning exposure with respect to the shot field SA1 to be exposed first is finished, the movement of the substrate stage 2 in the -Y direction is continued without decelerating the substrate stage 2. Moreover, the reflecting mirrors 30 and 42 at the positions 30e and 42e are moved to the scanning start positions 30s and 42s, before scanning of the mask M performed by the slit light EL reflected by the reflecting surface 22b following the reflecting surface 22a of the polygon mirror 22 is started with respect to the shot field SA2. The pattern field of the mask M is then scanned by the slit light EL in the same manner, and the reflecting mirrors 30 and 42 are synchronously moved. Accordingly, the pattern image of the mask M is sequentially projected onto the shot field SA2 arranged on the +Y side of the shot field SA1 on the substrate P. That is, in the embodiment, one row of shot fields arranged in the Y direction is continuously exposed by one scan (step S 15).

When the exposure to the shot field SA2 is finished, the control apparatus 3 decelerates the substrate stage 2. The control apparatus 3 then determines whether the exposure of one substrate P has finished, that is, the whole exposure on the substrate P has finished (step S16). Here, since only the exposure to the shot fields SA1 and SA2 has just finished, and there are still shot fields to be exposed, the determination result in step S16 is "NO". Subsequently, the control apparatus 3 reverses the rotation direction of the polygon mirror 22 (step S 17). That is, the control apparatus 3 rotates the polygon mirror 22 in the clockwise direction in FIGS. 2 and 5. The control apparatus 3 then drives the substrate stage 2 to step the substrate P forward to the next exposure start position (step S 18). Specifically, the control apparatus 3 drives the substrate stage 2 so that the shot field SA3 to be exposed next is positioned near the -Y side of the projection field of the projection optical system PL. It is desired to reverse the rotation direction of the polygon mirror 22 in step S 17 while the movement of the substrate stage 2 in step S18 is being performed, in order to improve the throughput. Moreover, it is desired that the irradiation of the slit light EL to the mask M is not performed during the reverse operation of the rotation direction of the polygon mirror 22 (for example, to suspend the irradiation itself of the illumination light source or shade the light by using a shutter for shading, so as to temporarily stop the exposure of the substrate P).

The control apparatus 3 moves the reflecting mirrors 30 and 42, respectively, to the positions 30e and 42e corresponding to the scanning start position, accompanying inversion of the scanning direction of the exposure light EL with respect to the mask M. That is, the reflecting mirror 30 at the time of exposing the respective shot fields SA3 to SA6 in a second row moves from the position 30e to the position 30s in the +Y direction in FIG 5, and the reflecting mirror 42 moves from the position 42e to the position 42s in the +Z direction.

When the movement of the substrate P is finished, the control apparatus 3 sets the moving direction of the substrate stage 2 and the reflecting mirrors 30 and 42 to a reverse direction in order to perform exposure to the shot fields SA3 to SA6 positioned in the second row as a direction switching device, to start movement of the substrate stage 2 and the reflecting mirror 3 0 in the +Y direction, and start movement of the reflecting mirror 42 in the +Z direction (step S 19). When the end of the shot field SA3 on the +Y side reaches the projection field after the movement speed of the substrate P in the +Y direction and an angular velocity of the polygon mirror 22 are constant to achieve synchronization, the control apparatus 3 emits the slit light EL from an illumination optical system ILS to scan the mask M via the reflecting surface 22b of the polygon mirror 22, and projects the image of the pattern of the mask M onto the substrate P via the projection optical system PL.

At this time, in a state with a part of the pattern image of the mask M projected onto the projection field, the substrate P moves in the +Y direction at a speed of β·V with respect to the projection optical system PL, synchronously with the movement of the slit light EL on the mask M in the +Y direction at a speed of V. Then the shot fields SA3 to SA6 arranged in the Y direction are sequentially exposed. At this time, the shot fields SA3 to SA6 are respectively exposed by the slit light EL reflected in the order of the reflecting surfaces 22b, 22a, 22h, and 22g of the polygon mirror 22.

At the time of the exposure to the shot fields SA3 to SA6 in the second row, the reflecting mirror 42 moves from the position 42e to the position 42s, accompanying the movement of the reflecting mirror 30 from the position 30e to the position 30s, to thereby correct the optical path length of the slit light to be constant.

Every time the exposure of shot fields in one line arranged in the Y direction finishs, the rotation direction of the polygon mirror 22 is reversed and the moving direction (scanning direction) of the substrate stage 2 and the reflecting mirrors 30 and 42 are also reversed to perform the exposure process in a line unit (steps S 15 to S 19). The above operation is repeated. When the control apparatus 3 determines that the whole exposure on the substrate P has finished (when the determination result in step S16 is "YES"), the control apparatus 3 unloads the substrate P loaded on the substrate stage 2 (step S20). The control apparatus 3 then determines whether there is another substrate P to be exposed next (step S21). When there is the substrate P to be exposed, the determination result is "YES", and the processing from step S11 is repeated. On the other hand, when there is no substrate P to be exposed, the determination result is "NO", and the series of exposure processing is finished.

In the present embodiment, as described above, the slit light EL moves toward the pattern field of the mask M to scan. Therefore, it is not necessary to install the drive device for driving the mask stage 1 with a large stroke (the mask M can be fixed (stationary) without being moved to scan) at the time of the scanning exposure, and hence, the present embodiment can contribute to smaller size and weight of the apparatus and a decrease of vibrations generated on the apparatus. In the present embodiment, the exposure is not performed, as in the conventional apparatus, while frequently changing the scanning direction of the substrate stage 2 for each shot field, but the shot fields in one line arranged in the scanning direction (the Y direction) are continuously exposed without changing the scanning direction of the substrate stage 2, thereby enabling an improvement in the exposure accuracy and the throughput.

In the present embodiment, the aforementioned effect of enabling the scanning exposure without moving the mask M to scan can be obtained by a simple configuration in which the reflecting mirror 30 synchronously moves with the polygon mirror 22.

In the present embodiment, since the equivalent of the fluctuation of the optical path length of the slit light EL that reaches the substrate P is corrected to be constant by the correction optical system 40, fluctuation in an energy amount to be irradiated to the substrate P accompanying the fluctuation of the optical path length can be controlled, and quality deficiencies of the pattern to be formed on the substrate P such as fluctuations in pattern line width can be suppressed.

### <Second embodiment>

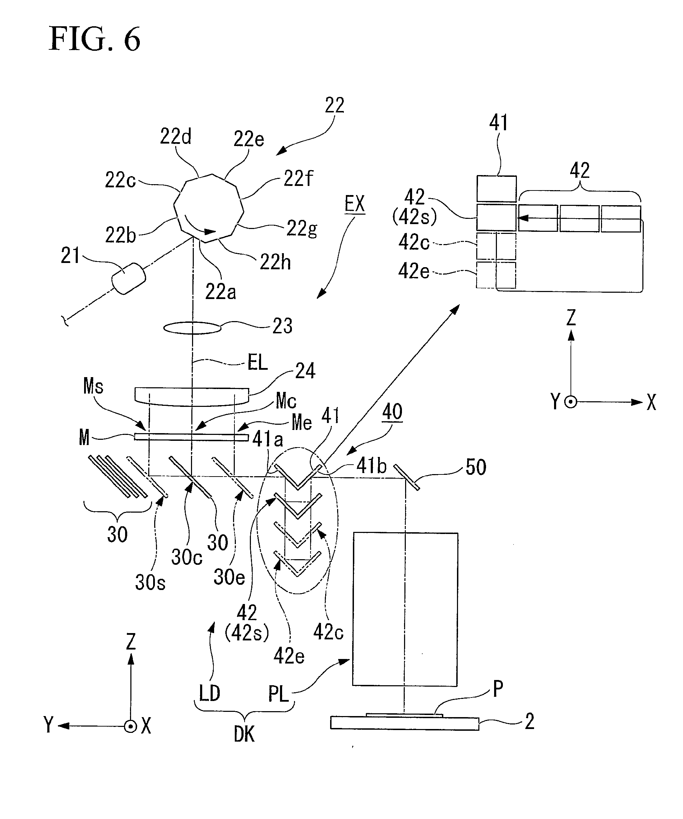

A second embodiment of the present invention will be described with reference to FIG 6. The overall configuration of an exposure apparatus in the second embodiment is substantially the same as that of the exposure apparatus EX in the first embodiment shown in FIGS. 2 to 5, but the configuration of the reflecting mirror 30 is different.

FIG 6 is a schematic block diagram showing the exposure apparatus according to the second embodiment. In FIG. 6, components the same as or similar to the abovementioned first embodiment shown in FIGS. 2 and 5 are denoted by the same reference symbols, and their description is omitted.

As shown in FIG 6, in an exposure apparatus EX, a plurality of reflecting mirrors 30 and a plurality of reflecting mirrors 40 are provided. More specifically, in the exposure apparatus EX, the reflecting mirrors 30 and 40 are provided in the same number (four) as the maximum number (four) of shot fields in one line arranged on a substrate P in the scanning direction.

When a polygon mirror 22 rotates in the counterclockwise direction, the reflecting mirrors 30 wait at positions (three positions shown in FIG. 6) on the +Y side in FIG. 6, and the reflecting mirrors 42 wait at positions (three positions shown in FIG 6) on the +X side of position 42s in FIG 6. When the polygon mirror 22 rotates in the clockwise direction, it is assumed that the reflecting mirrors 30 wait below position 30e (in the -Z direction), and the reflecting mirrors 42 wait at positions on the +X side of position 42e.

The respective reflecting mirrors 30 and 40 independently move under the control of the control apparatus 3.

In the above configuration, the respective reflecting mirrors 30 and 40 are sequentially moved synchronously with the scan of slit light EL, while the reflecting mirrors 30 and 40 to be used for each scan (for each shot field) with respect to a mask M are changed over, thereby enabling to reflect the slit light EL that illuminates the mask M toward the reflecting mirror 50.

That is, in the present embodiment, as in the case of using one reflecting mirror 30, for example, when a shot field SA2 is to be exposed after exposure to a shot field SA1, the reflecting mirrors 30 and 42, which are at positions 30e and 42e, need not be moved to scanning start positions 30s and 42s before scanning of the mask M is started. Therefore, the throughput can be improved by increasing the rotation speed of the polygon mirror 22 and the moving speed of the reflecting mirrors 30 and 42 and the substrate stage 2 (in this case, however, the reflecting mirror used for the previous scan is kept away from a scanning end position 30e, before the reflecting mirror 30 reaches the scanning end position 30e).

In the second embodiment, the reflecting mirror 30 is provided in the same number as the number of shot lines in the scanning direction, however, the number of the reflecting mirrors 30 is not limited thereto. For example, the configuration may be such that two reflecting mirrors 30 are provided, and after the reflecting mirrors 30 are moved synchronously with the scan of the slit light EL, the reflecting mirrors 30 are moved in a movement path different from the synchronous movement path to return to the scanning start positions and move in a cycle. Even when this configuration is adopted, the same effect as that of the second embodiment can be obtained.

### <Third embodiment>

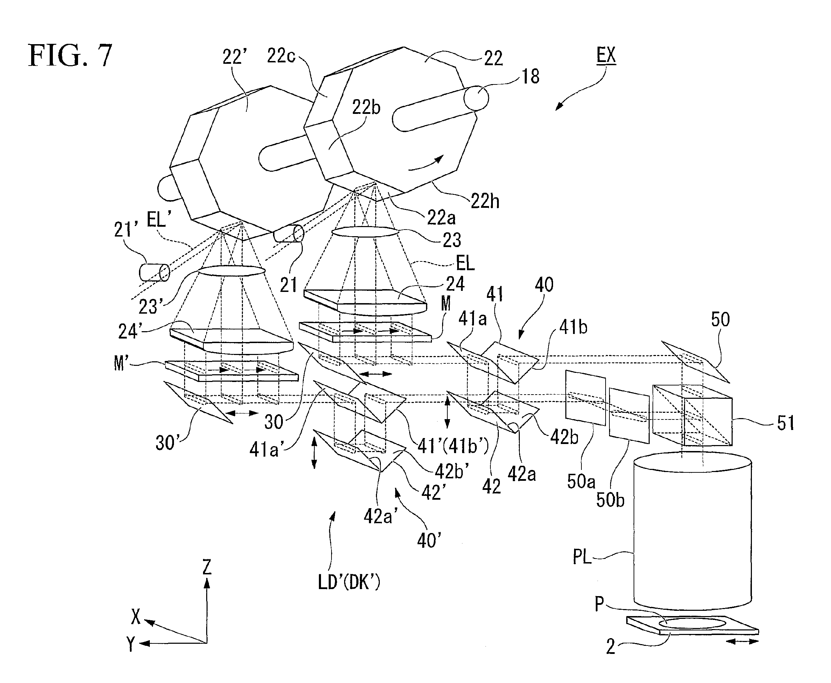

Next, a third embodiment will be described with reference to FIG. 7. In the overall configuration of an exposure apparatus in the third embodiment, components such as the polygon mirror, the mask, and the optical guiding device are provided in pairs separately, to thereby perform simultaneous double exposure (multiple exposure) with respect to the exposure apparatus EX in the first embodiment shown in FIGS. 2 and 5. This will be described in detail. In FIG 7, components the same as or similar to the abovementioned first embodiment shown in FIGS. 2 and 5 are denoted by the same reference symbols, and their description is omitted.

As shown in FIG 7, in the exposure apparatus EX in the present embodiment, a correcting lens 21', a polygon mirror 22' (second scanning device), an fθ lens 23', a telecentric lens 24', a mask M' (mask stage 1', third object), and a second optical guiding device DK' (conduction apparatus LD') having the same configuration as a correcting lens 21, a polygon mirror 22, an fθ lens 23, a telecentric lens 24, a mask M (mask stage 1), and an optical guiding device DK (conduction apparatus LD) are provided in parallel.

Slit light (second illumination beams) EL' irradiated via the correcting lens 21' is reflected by the reflecting surface of the polygon mirror 22', and telecentrically illuminates the mask M' via the fθ lens 23' and the telecentric lens 24'. The polygon mirror 22' is supported on a spindle 18 and rotates integrally with the polygon mirror 22.

A pattern to be exposed in the shot field on the substrate P is arranged on the mask M' together with the pattern of the mask M so as to face the same direction. As a pattern to be formed on the masks M and M', the following patterns can be used. (1) A pattern in which a line-and-space and an isolated line having different exposure parameters are formed individually on separate masks and these are double exposed on the same substrate P according to respective optimum exposure conditions. (2) A pattern in which all the patterns are formed with a line-and-space by one mask and an isolated line is formed by thinning (thinning out) the line-and-space using the other mask, based on the fact that when a phase shift method or the like is introduced, the line-and-space has higher theoretical resolution limitation than the isolated line with the same depth of focus (DOF). (3) A pattern in which the line-and-space is formed by a combination of the isolated lines respectively formed by the masks M and M' by forming all the patterns using the isolated lines, because the isolated line can generally obtain higher resolution with a small N.A. than the line-and-space (though DOF becomes small). The technology for forming the pattern by double exposure on the substrate P is disclosed in for example Japanese Patent Application, Publication No. 10-214783 A.

The conduction apparatus LD' includes a reflecting mirror 30' (movable reflecting member) provided on the -Z side of the mask M' to bend the slit light EL' toward -Y direction transmitted through the mask M', a correction optical system 40' (correcting device) that corrects differences in optical path lengths of the slit light EL', and reflecting mirrors 50a and 50b that bend the slit light EL' having passed through the correction optical system 40' to make the slit light EL' enter into a polarized beam splitter 51 arranged immediately before the projection optical system PL. The reflecting mirror 30' moves in the Y axis direction synchronously with the rotation of the polygon mirror 22' under the control of the control apparatus 3.

The correction optical system 40' has reflecting mirrors 41' and 42'. The respective reflecting mirrors 41' and 42' have reflecting surfaces 41a' and 41b', and reflecting surfaces 42a' and 42b' that bend the slit light EL' entering into positions facing each other by 90 degrees. The slit light EL' reflected by the reflecting mirror 30' is sequentially reflected by the reflecting surface 41 a' of the reflecting mirror 41', the reflecting surfaces 42a' and 42b' of the reflecting mirror 42', the reflecting surface 41b of the reflecting mirror 41', and the reflecting surface of the reflecting mirror 50a and the reflecting surface of the reflecting mirror 50b to enter into the polarized beam splitter (or half mirror) 51. As in the correction optical system 40, the reflecting mirror 42' moves in the Z axis direction, so as to be movable toward and away from the reflecting mirror 41' under the control of the control apparatus 3, to correct the optical path length of the slit light EL'.

The pattern light of the mask M reflected by the reflecting mirror 50 also enters into the polarized beam splitter 51.

In the exposure apparatus EX, the slit light EL scans the pattern field of the mask M in the -Y direction due to the rotation of the polygon mirror 22 while moving the substrate P, and the reflecting mirrors 30 and 42 move synchronously with the scan. Therefore, the pattern image of the mask M is sequentially exposed in the shot field on the substrate P in a state with the optical path length of the slit light EL kept constant. The slit light EL' scans the pattern field of the mask M' in the -Y direction due to the rotation of the polygon mirror 22', and the reflecting mirrors 30' and 42' move synchronously with the scan. Therefore, the pattern image of the mask M' is sequentially exposed in the shot field on the substrate P in a state with the optical path length of the slit light EL' kept constant.

The exposure field in the shot field on the substrate P by the pattern image of the mask M reflected by the reflecting mirror 50, and the exposure field in the shot field on the substrate P by the pattern image of the mask M' reflected by the reflecting mirror 50b can be superposedly projected on each other (slit synthesis method), or the respective exposure fields can be projected slightly shifted in the scanning direction (Y direction) in the shot (slit separation method). In this case, the polarized beam splitter 51 is not required, and hence, there is a merit of no restriction of the polarization direction.

Accordingly, in the present embodiment, the drive device for moving the mask with a large stroke need not be installed, even when the double exposure is performed using a plurality of patterns, thereby enabling to contribute to smaller size and weight of the apparatus. Since shot fields in one line arranged in the scanning direction (Y direction) are continuously exposed without changing the scanning direction of the substrate stage 2, the exposure accuracy can be improved without causing a considerable cost increase of the exposure apparatus EX.

In the present embodiment, the patterns formed by the simultaneous double exposure are formed by using two masks M and M', however, the patterns to be multiple-exposed can be respectively formed on one mask.

### <Forth embodiment>

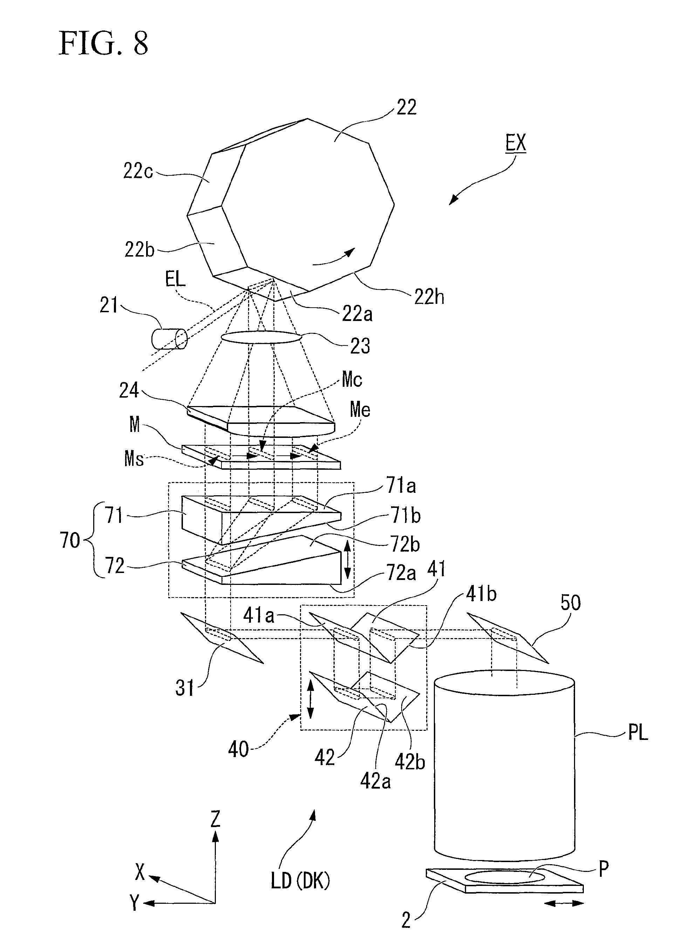

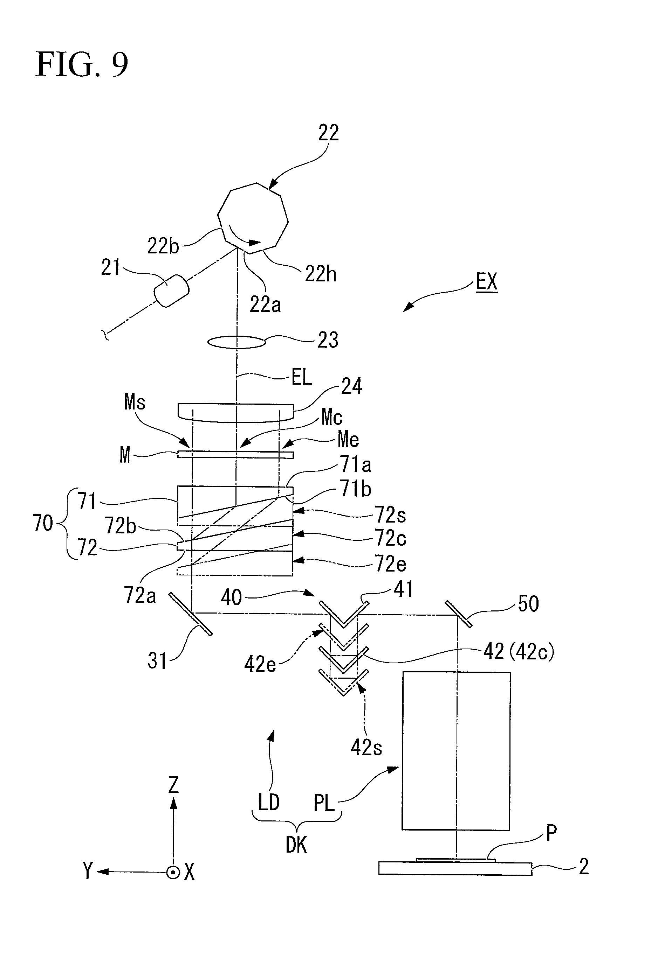

Next, a fourth embodiment of the present invention will be described with reference to FIGS. 8 and 9. The overall configuration of an exposure apparatus in the present embodiment is such that with respect to the exposure apparatus EX in the first embodiment shown in FIGS. 2 and 5, a concentrating optical system that concentrates the slit light having scanned the mask is provided in a conduction apparatus LD. This will be described in detail. In FIGS. 8 and 9, components the same as or similar to the abovementioned first embodiment shown in FIGS. 2 and 5 are denoted by the same reference symbols, and their description is omitted.

As shown in FIG 8, a concentrating optical system (concentrating device) 70 that concentrates the slit light EL having scanned the mask M in the Y axis direction at a predetermined position in the Y axis direction, is provided in the conduction apparatus LD in the exposure apparatus EX of the present embodiment.

The concentrating optical system 70 has a pair of trapezoidal optical members (displacement members) 71 and 72 having a trapezoid shape as seen from the front, arranged along the Z axis direction. The trapezoidal optical member 71 has a surface 71 a parallel to an XY plane on an incoming side of the slit light EL, and a surface 71b on an outgoing side of the slit light EL obtained by inclining a surface parallel to the XY plane about the X axis, with the +Y side inclined toward the -Z side.

Likewise, the trapezoidal optical member 72 has a surface 72a parallel to the XY plane on the outgoing side of the slit light EL, and a surface 72b facing the surface 72b parallel thereto on the incoming side of the slit light EL. The trapezoidal optical member 72 moves in the Z axis direction synchronously with the rotation of the polygon mirror 22 under the control of the control apparatus 3, to thereby displace the optical path of the slit light in the Y axis direction by a displacement amount corresponding to the relative position with respect to the trapezoidal optical member 71.

A reflecting mirror 31 that bends the exposure light EL transmitted through the mask M and the concentrating optical system 70 toward the correction optical system 40 in the -Y direction is fixedly arranged on the -Z side of the trapezoidal optical member 72.

Other configurations are the same as those in the first embodiment.

In the exposure apparatus EX having the above configuration, when the slit light EL is at the scanning start position Ms with respect to the pattern field of the mask M, the trapezoidal optical member 72 is positioned at a position 72s (position shown by two-dot chain line in FIG 9) where the surface 72b abuts against the surface 71b of the trapezoidal optical member 71. At this time, the slit light EL that illuminates the scanning start position Ms of the mask M enters into the trapezoidal optical members 71 and 72 integrally abutting against each other from the surface 71a, and is emitted from the surface 72a without being refracted and reflected by the reflecting mirror 31. Then as the polygon mirror 22 rotates and the position of the slit light EL for illuminating the pattern field of the mask M moves from the scanning start position Ms to the scanning end position Me via the center of the mask Mc (synchronously with the movement thereof), the control apparatus 3 makes the trapezoidal optical member 72 move with uniform speed from the position 72s via the position 72c corresponding to the center of the mask Mc toward a position 72e corresponding to a scanning end position Me on the -Z side.

Since the trapezoidal optical member 72 moves from the position 72s, a gap is generated between the trapezoidal optical members 71 and 72. The slit light EL is refracted and emitted from the surface 71b of the trapezoidal optical member 71 and refracted to enter into the surface 72b of the trapezoidal optical member 72. Therefore, the incident position of the slit light EL on the surface 71a and the outgoing position on the surface 72a change corresponding to the gap between the trapezoidal optical members 71 and 72. That is, the position of the slit light EL to be emitted from the surface 72a can be concentrated at a certain position by adjusting the position of the trapezoidal optical member 72 in the Z axis direction. The optical path of the slit light EL reflected by the reflecting mirror 31 can be made constant, even when the incident position of the slit light EL moved by the scan changes with respect to the concentrating optical system 70, by setting the position for entering onto the reflecting mirror 31 to be constant at all times.

The optical path length of the slit light EL reflected by the reflecting mirror 31 changes corresponding to the position where it transmits through the trapezoidal optical members 71 and 72 (displacement between the position entering into the trapezoidal optical member 71 and the position emitted from the trapezoidal optical member 72). As in the aforementioned embodiment, the slit light EL reflected by the reflecting mirror 31 and entering into the correction optical system 40 is corrected to a constant optical path length by moving the reflecting mirror 42 in the Z axis direction, thereby enabling to reduce quality deficiencies of the pattern formed on the substrate P such as fluctuations in the pattern line width. At this time, in contrast to the aforementioned first embodiment, when the trapezoidal optical member 72 is at the position 72s, the displacement amount of the slit light EL becomes small, and the optical path length is short, the reflecting mirror 42 is at the position 42s farthest from the reflecting mirror 41 to increase the optical path length of the slit light EL. When the trapezoidal optical member 72 is at the position 72e, the displacement amount of the slit light EL is large, and the optical path length becomes long, the reflecting mirror 42 is at the position 42e closest to the reflecting mirror 41 to decrease the optical path length. Accordingly, the slit light EL enters into the projection optical system PL with a constant optical path length, regardless of the position for scanning (illuminating) the mask M.

When the scanning exposure with respect to the shot field SA1 to be exposed first is finished, the movement of the substrate stage 2 in the -Y direction is continued without decelerating the substrate stage 2. The trapezoidal optical member 72 and the reflecting mirror 42 at the positions 72e and 42e need to be moved to the scanning start positions 72s and 42s, respectively, before starting scanning of the mask M by the slit light EL reflected by the reflecting surface 22b of the polygon mirror 22 following reflection by the reflecting surface 22a, with respect to the shot field SA2.

In the present embodiment, in addition to obtaining the same action and effect as in the first embodiment, the slit light EL having scanned the mask M is concentrated to enter onto the reflecting mirror 31. Therefore, it is not required to move the reflecting mirror 31 synchronously with the scan, thereby enabling simplification of the apparatus.

In the present embodiment, the slit light EL is concentrated to a predetermined position by the concentrating optical system 70, however, the present invention is not limited thereto. For example, the slit light EL can be concentrated to a predetermined field by the concentrating optical system 70, and the reflecting mirror 31 is moved within the field so that the slit light EL enters into the correction optical system 40. Also with this configuration, the same action and effect as with the present embodiment can be obtained. Even when the concentrating optical system 70 of the present embodiment is used, the simultaneous double exposure explained in the third embodiment can be executed by providing the same configuration separately.

### <Fifth embodiment>

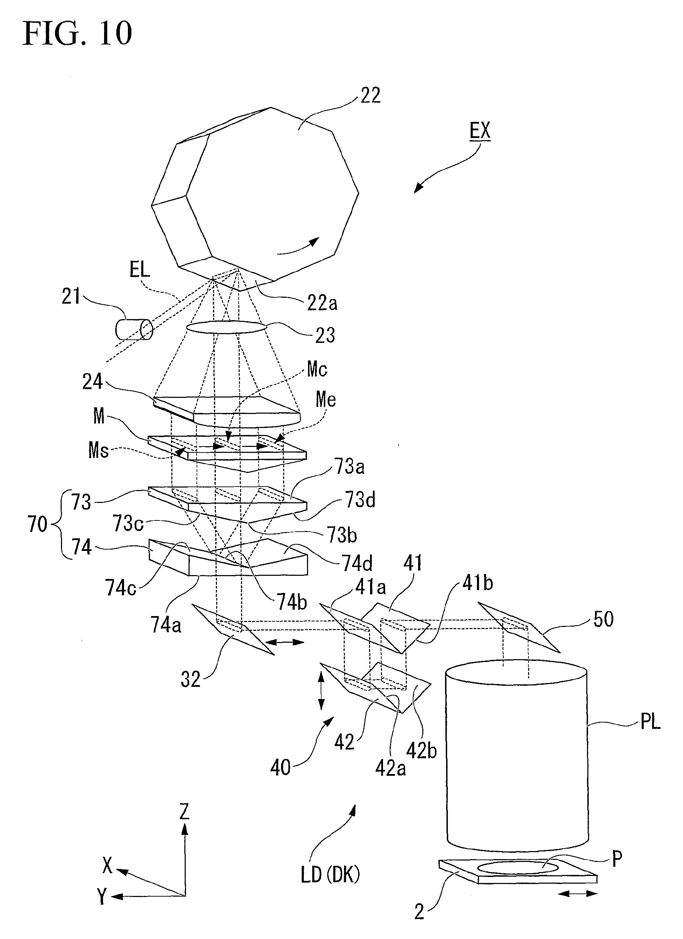

A fifth embodiment of the present invention will be described with reference to FIGS. 10 to 12C. In the present embodiment, another form of the concentrating optical system 70 described in the fourth embodiment will be described.

In FIGS. 10 to 12C, components the same as or similar to the abovementioned fourth embodiment shown in FIGS. 8 and 9 are denoted by the same reference symbols, and their description is omitted.

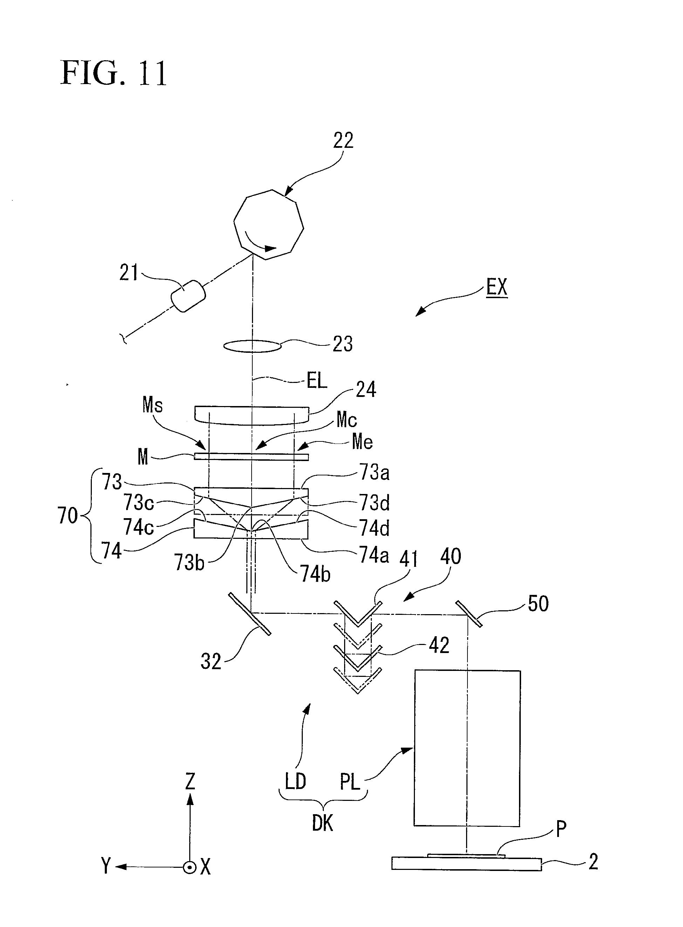

As shown in FIGS. 10 and 11, the concentrating optical system 70 in the present embodiment has a convex member 73 and a concave member 74 arranged along the Z axis direction. The convex member 73 has a surface 73 a parallel to the XY plane on the incoming side of the slit light EL, and has an apex 73b having a ridge line extending in the X axis direction at a central position of the mask M (pattern field) in the Y axis direction, an inclined surface 73 c inclined toward the +Z side going toward the +Y direction from the apex 73b as a base end, and an inclined surface 73d inclined toward the +Z side going toward the -Y direction from the apex 73b as the base end, on the outgoing side of the slit light EL.

The concave member 74 has a surface 74a parallel to the XY plane on the outgoing side of the slit light EL, and has inclined surfaces 74c and 74d respectively facing the inclined surfaces 73c and 73d in parallel therewith on the incoming side of the slit light EL. The inclined surfaces 74c and 74d are provided, designating a valley line 74b having a ridge line facing the apex 73b as a base end. The concave member 74 moves in the Z axis direction synchronously with the rotation of the polygon mirror 22 under the control of the control apparatus 3, to thereby displace the optical path of the slit light EL in the Y axis direction by a displacement amount corresponding to the relative position with respect to the convex member 73. Since the valley line 74b and the inclined surfaces 74c and 74d abut against the apex 73b and the inclined surfaces 73c and 73d of the convex member 73, a hexahedral optical device is integrally formed by the concave member 74 and the convex member 73.

When arranged with a space between each other, the convex member 73 and the concave member 74 displace the slit light EL entering into the field on the +Y side (first field) away from the center of the mask toward the -Y side, and displace the slit light EL entering into the field on the -Y side (second field) away from the center of the mask toward the +Y side.

The reflecting mirror 32 that bends the exposure light EL transmitted through the mask M and the concentrating optical system 70 toward the correction optical system 40 in the -Y direction is arranged on the -Z side of the concave member 74, moveably in the Y axis direction under the control of the control apparatus 3.

Other configurations are the same as those in the fourth embodiment.

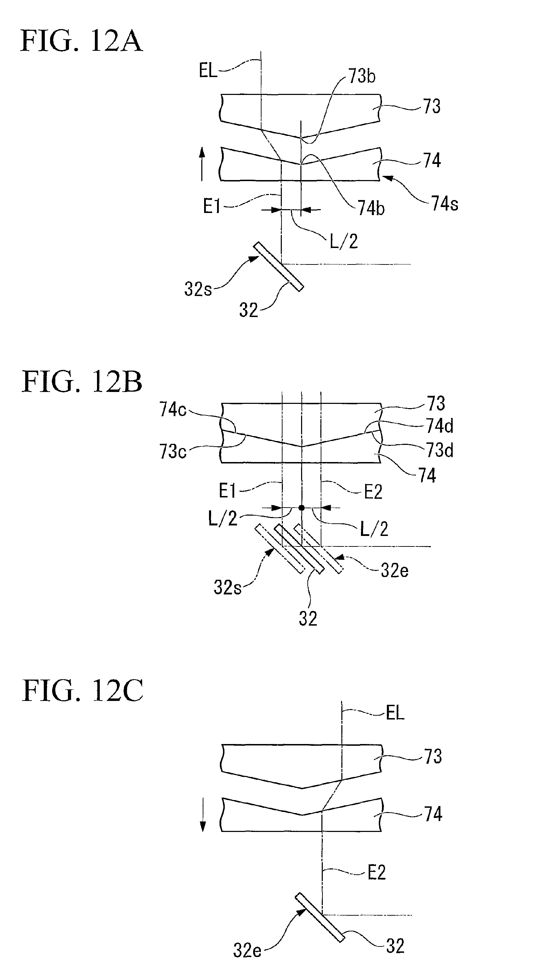

In the exposure apparatus EX, when the slit light EL is at the scanning start position Ms with respect to the pattern field of the mask M, then as shown in FIG 12A, the concave member 74 is away from the convex member 73 and the concave member 74 is arranged at a position 74s. In the position 74s, if it is assumed that the width of the slit light EL is L, the concave member 74 refracts the slit light EL to be concentrated at a position (first position) E1, L/2 away from the center of the mask in the Y axis direction toward the +Y direction (that is, a position where the slit light EL having the width L is not shone onto the valley line 74b). Moreover the reflecting mirror 32 is positioned at a position 32s where the slit light EL entering into the position E1 is reflected toward the correction optical system 40.

The polygon mirror 22 rotates, and the position where the slit light EL illuminates the pattern field of the mask M moves at a uniform speed from the scanning start position Ms toward the mask center Mc in the -Y direction. Accompanying this (synchronously therewith), the concave member 74 gradually moves in a direction approaching from the position 74s to the convex member 73 (+Z direction) so that the concentrated position of the slit light EL is maintained.

With the progress of the scan, when the slit light EL reaches the valley line 74b of the concave member 74, then as shown in FIG. 12B, the valley line 74b and the inclined surfaces 74c and 74 of the concave member 74 respectively abut against the apex 73b and the inclined surfaces 73c and 73d of the convex member 73. At this time, since the slit light EL transmits through the convex member 73 and the concave member 74 without refraction, the position for emitting the slit light EL from the concave member 74 also moves synchronously with the scan with respect to the mask M. Therefore, the control apparatus 3 causes the reflecting mirror 32 to move from the position 32s in the -Y direction at the same speed as the moving speed of the slit light EL, synchronously with the movement of the slit light EL. Accordingly, the slit light EL is reflected by the reflecting mirror 32, and enters into the correction optical system 40 on the same optical path (optical path in the Z axis direction) as when the reflecting mirror 32 is positioned at the position 32s.

With the progress of the scan, when the slit light EL reaches a position (second position) E2, L/2 away from the mask center in the -Y direction, where the slit light EL is away from the valley line 74b of the concave member 74, the reflecting mirror 32 is positioned at the position 32e. At the position 32e, the reflecting mirror 32 reflects the slit light EL emitted from the concave member 74 at the position E2 toward the correction optical system 40. With further progress of the scan, as shown in FIG 12C, the control apparatus 3 causes the concave member 74 to gradually move in a direction away from the abutment position with the convex member 73 (-Z direction) so that the concentrated position E2 of the slit light EL is maintained.

In the present embodiment, the optical path length of the slit light EL reflected by the reflecting mirror 32 is corrected to a constant optical path length, because the reflecting mirror 42 in the correction optical system 40 moves in the Z axis direction. The slit light EL enters into the projection optical system PL with the constant optical path length, regardless of the position for scanning (illuminating) the mask M. Therefore, the same effects as those in the fourth embodiment can be obtained. When the slit light EL transmits through the valley line 74b, since the convex member 73 and the concave member 74 abut against each other, problems such as the width of the slit light EL fluctuating can be avoided.

Also in the present embodiment, when the scanning exposure with respect to the shot field SA1 to be exposed first is finished, the movement of the substrate stage 2 in the -Y direction is continued without decelerating the substrate stage 2. The reflecting mirror 32 at the position 32e needs to be moved to the scanning start position 32s, before starting scanning of the mask M by the slit light EL reflected by the reflecting surface 22b of the polygon mirror 22 following reflection by the reflecting surface 22a, with respect to the shot field SA2 (here, the concave member 74 needs not to move, since the scanning start position thereof is the same as the scanning end position). Needless to say, even when the concentrating optical system 70 in the present embodiment is used, the simultaneous double exposure explained in the third embodiment can be executed by providing the same configuration separately.

### <Sixth embodiment>

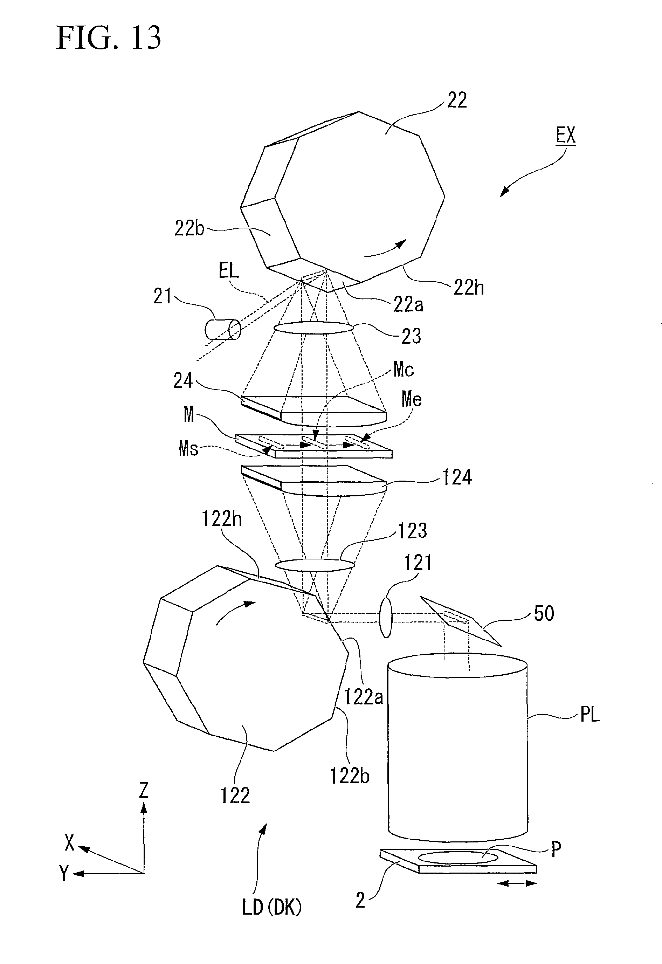

Next, a sixth embodiment of the present invention will be described with reference to FIG. 13. In the overall configuration of an exposure apparatus in the sixth embodiment, with respect to the exposure apparatus EX in the first embodiment shown in FIGS. 2 to 5, a polygon mirror is provided as a conduction apparatus LD.

This configuration will be described in detail. In FIG 13, components the same as or similar to the abovementioned first embodiment shown in FIGS. 2 and 5 are denoted by the same reference symbols, and their description is omitted.

As shown in FIG 13, a polygon mirror (second polygon mirror) 122 that causes slit light EL having scanned a mask M to enter into a projection optical system PL via a correcting lens 121 and a reflecting mirror 50 is provided in the conduction apparatus LD in the exposure apparatus EX in the present embodiment. An fθ lens 123 and a telecentric lens 124 having the same configuration as that of the fθ lens 23 and the telecentric lens 24, are arranged between the mask M and the polygon mirror 122.

The polygon mirror 122 has a plurality of reflecting surfaces 122a to 122h (eight in FIG. 13) on an outer circumference thereof, and the rotation thereof is controlled by the control apparatus 3. These reflecting surfaces 122a to 122h respectively have a surface including a position conjugate to a pattern field of the mask M. Other configurations are the same as those in the first embodiment, except that an optical path length-correction optical system is not provided.

In the exposure apparatus EX having the above configuration, the polygon mirror 122 rotates in the clockwise direction, synchronously with the rotation of the polygon mirror in the counterclockwise direction, to cause the slit light EL having scanned the mask M to enter into the projection optical system PL via the correcting lens 121 and the reflecting mirror 50. At this time, the slit light EL moves in the -Y direction accompanying the scanning of the mask M, and enters onto the reflecting surface (for example, reflecting surface 122a) of the polygon mirror 123 via the fθ lens 123 and the telecentric lens 124, while changing the incident angle. Since the inclination angle of the reflecting surfaces 122a to 122h that reflect the slit light EL also change with the change of the incident angle of the slit light EL, the slit light EL is reflected by the reflecting mirror 50 in a constant optical path at all times to enter into the projection optical system PL.

In the present embodiment, the reflecting surfaces 122a to 122h of the polygon mirror 122 are set at a position conjugate to the pattern field of the mask M, in addition to the same action and effect obtained in the first embodiment. Therefore, the optical path length of the slit light EL entering into the projection optical system PL can be kept constant. Moreover, in the present embodiment, the correction optical system 40 or the like provided in the aforementioned embodiments is not required, thereby enabling to realize miniaturization of the apparatus and cost reduction, and also enabling to eliminate an adverse effect of heat generated accompanying the drive of the reflecting mirror (deterioration of position measurement accuracy or the like due to air fluctuations or the like).

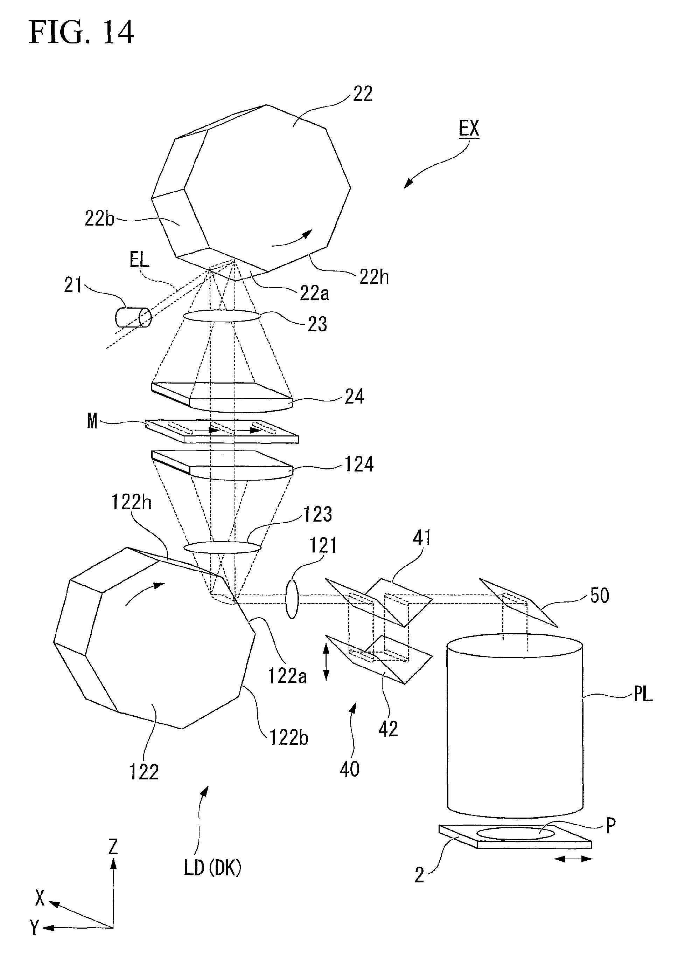

In the sixth embodiment, the reflecting surfaces 122a to 122h of the polygon mirror 122 are set at the position conjugate to the pattern field of the mask M. However, the embodiment is not limited thereto, and the reflecting surfaces 122a to 122h can be arranged away from the conjugate position. In this case, the optical path length of the slit light EL is changed due to the scan to the mask M. Therefore, as shown in FIG 14, it is desired to arrange a correction optical system 40 that corrects the optical path length of the slit light EL, which is reflected by the polygon mirror 122 and enters into the projection optical system PL. The operation of the correction optical system 40 is the same as that in the aforementioned embodiments.

Also in the present embodiment, the simultaneous double exposure explained in the third embodiment can be executed by providing the same configuration separately.

### <Seventh embodiment>

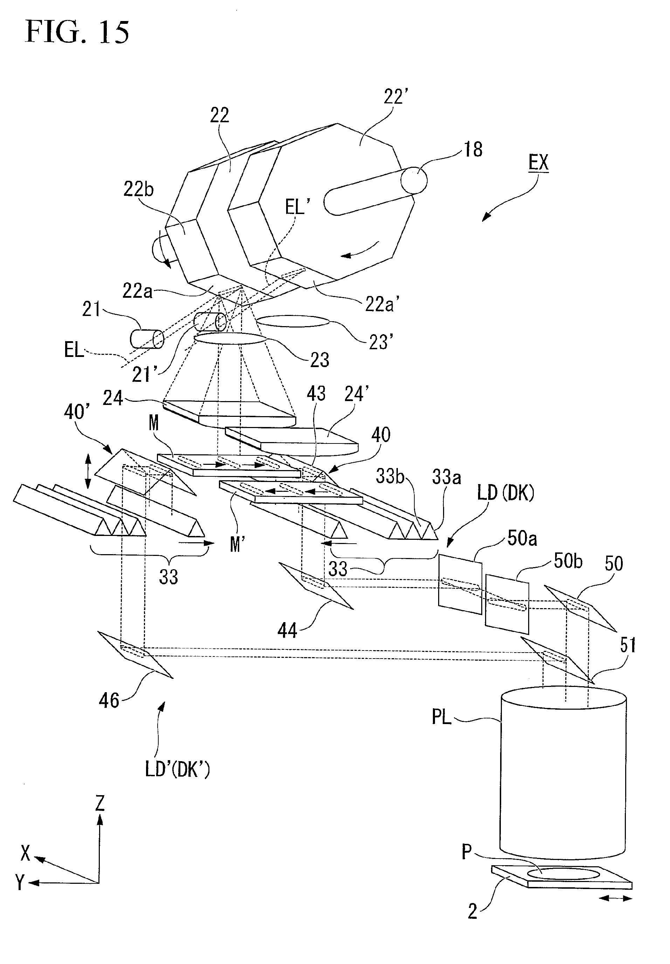

Next, a seventh embodiment of the present invention will be described with reference to FIGS. 15 to 18D. In the present embodiment, components such as the polygon mirror, the mask, and the optical guiding device are provided in pairs separately as in the third embodiment, but the configurations of a conduction apparatus and a correction optical system in the optical guiding device are different. This will be described in detail. In FIGS. 15 to 18D, components the same as or similar to the abovementioned third embodiment shown in FIG 7 are denoted by the same reference symbols, and their description is omitted.

As shown in FIGS. 15 to 17, in an exposure apparatus EX of the present embodiment, a correcting lens 21', a polygon mirror 22' (second scanning device), an fθ lens 23', a telecentric lens 24', a mask M' (mask stage 1', third object), and a second optical guiding device DK' (conduction apparatus LD') having the same configuration as those of the correcting lens 21, the polygon mirror 22, the fθ lens 23, the telecentric lens 24, the mask M (mask stage 1), and the optical guiding device DK (conduction apparatus LD) are provided in parallel, with a space in the X axis direction.

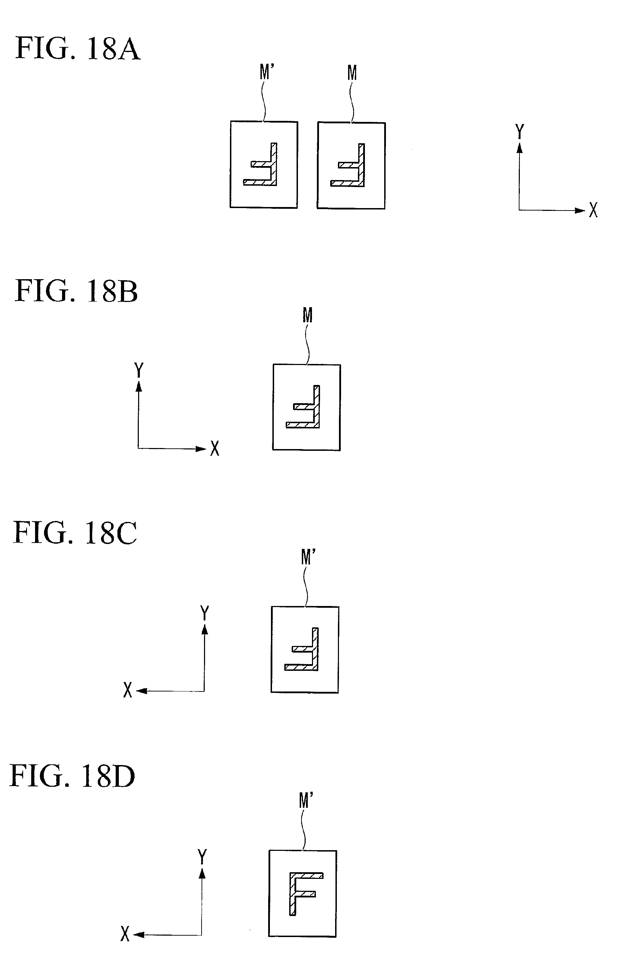

Patterns to be transferred in an inverted image onto a substrate P are formed on the masks M and M', as shown in FIG 18A, so that the patterns face the same direction as each other.

In the present embodiment, a plurality of (eight in FIG 15) reflecting mirrors (movable reflecting member) 33 to be shared by the conduction apparatuses LD and LD' (that is, optical guiding devices DK and DK'), a correction optical system 40 that corrects the optical path length of the slit light EL, and a correction optical system 40' that corrects the optical path length of the slit light EL' are provided.

The respective reflecting mirrors 33 are respectively movable in the Y axis direction under the control of the control apparatus 3, and are formed in a triangle as seen from the front, having a reflecting surface (first reflecting surface) 33a facing the -Y direction for reflecting the slit light EL having scanned the mask M to the -Y direction (to one side of the moving direction) and a reflecting surface (second reflecting surface) 33b facing the +Y direction for reflecting the slit light EL having scanned the mask M' to the +Y direction (to the other side of the moving direction). These reflecting surfaces 33a and 33b are arranged extending in the X axis direction with a length including the pattern field of the masks M and M'. These reflecting mirrors 33 constitute a part of the correction optical systems 40 and 40' described later.

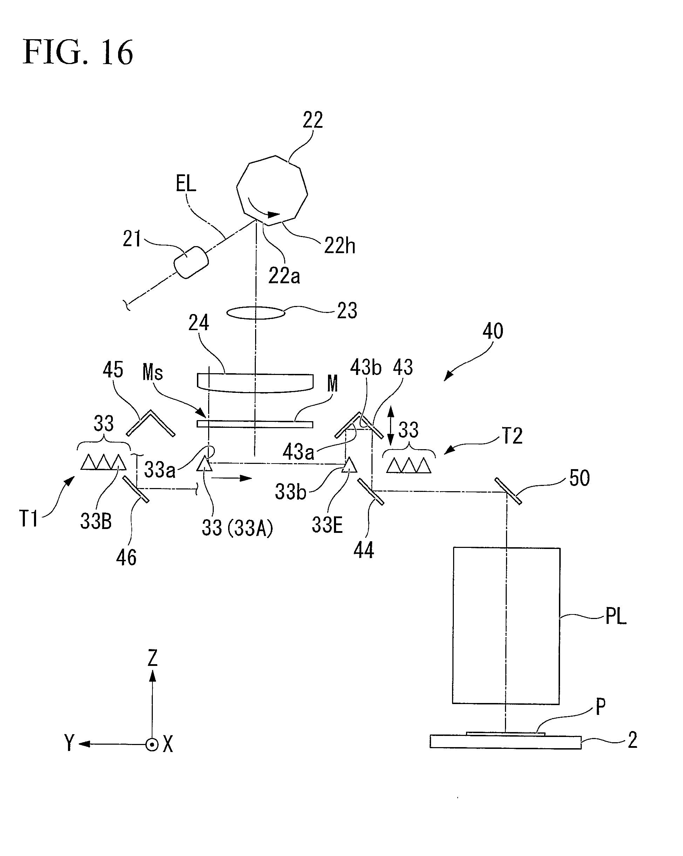

As shown in FIGS. 15 and 16, the correction optical system 40 includes a reflecting mirror 43 having a right-angled intersection angle and substantially V shape as seen from the front arranged on the -Y side of the mask M, and a reflecting mirror 44 arranged on the -Z side of the reflecting mirror 43 for reflecting the slit light EL reflected by the reflecting mirror 43 toward the reflecting mirror 50. The reflecting mirror 43 has reflecting surfaces 43 a and 43b that sequentially bend the slit light EL in the -Z direction, which has been reflected in the +Z direction by the reflecting mirror 33 positioned at a correction position on the -Y side. The reflecting mirror 43 moves in the Z axis direction, so as to be freely positioned away from or close to the reflecting mirrors 33 and 44 under the control of the control apparatus 3.

The light reflected by the reflecting mirror 50 enters into the projection optical system PL via a polarized beam splitter (or half mirror) 51.

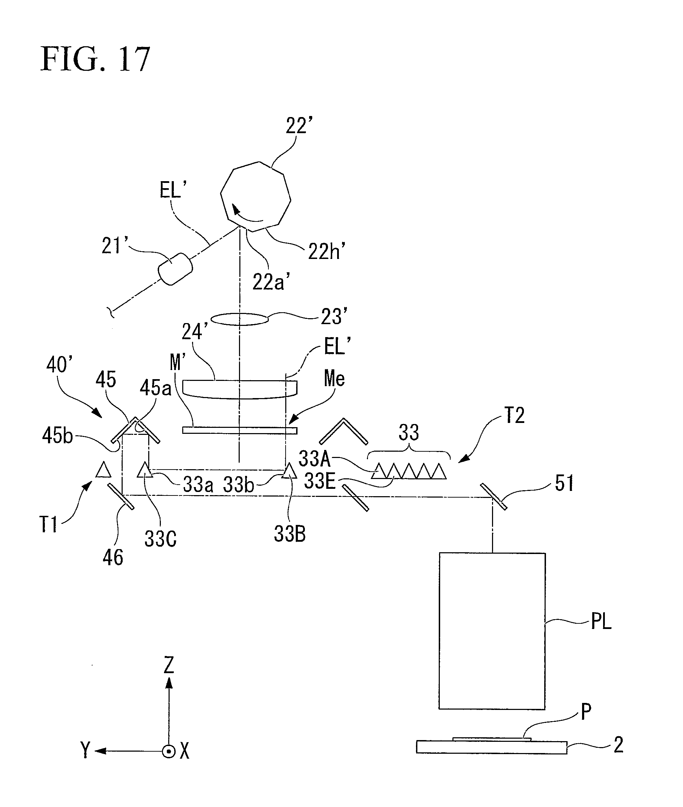

As shown in FIGS. 15 and 17, the correction optical system 40' includes a reflecting mirror 45 having a right-angled intersection angle and substantially V shape as seen from the front arranged on the +Y side of the mask M', and a reflecting mirror 46 arranged on the -Z side of the reflecting mirror 45 for reflecting the slit light EL' reflected by the reflecting mirror 45 toward the reflecting mirror 50a. The reflecting mirror 45 has reflecting surfaces 45a and 45b that sequentially bend the slit light EL' in the -Z direction, which has been reflected in the +Z direction by the reflecting mirror 33 positioned at a correction position on the +Y side. The reflecting mirror 45 also moves in the Z axis direction, so as to be freely positioned away from or close to the reflecting mirrors 33 and 46 under the control of the control apparatus 3. The correction optical system 40 constitutes a first reflecting system and the correction optical system 40' constitutes a second reflecting system. The light reflected by the reflecting mirror 50a is reflected by the reflecting mirror 50b and then enters into the polarized beam splitter (or half mirror) 51.

In the exposure apparatus EX having the aforementioned configuration, when the shot field SA1 on the substrate P shown in FIG 4 is to be exposed, then as shown in FIG 16, the reflecting mirror 33 (denoted by reference symbol 33A in FIG 16) is positioned beforehand at a position corresponding to the scanning start position Ms of the slit light EL with respect to the mask M. At this time, the same number of the reflecting mirrors 33 as that of the shot fields (here, three) following at least from the shot field SA1 are arranged at a wait position T1. Below the reflecting mirror 43 (in the -Z direction), a reflecting mirror (denoted by reference symbol 33E in FIG. 16) is arranged at a position for reflecting the slit light EL reflected by the reflecting mirror 33A by a reflecting surface 33b toward the reflecting mirror 43. In a wait position T2 on the -Y direction side of the reflecting mirror 33E, the reflecting mirrors 33 to be used for exposing the shot fields SA3 to SA6 in the next line are arranged.

The wait position T2 is set at a position away from the optical path of the slit light EL between the reflecting mirrors 43 and 44. The wait position T1 is also set at a position away from the optical path of the slit light EL' between the reflecting mirrors 45 and 46.

When the shot fields in odd lines including the shot fields SA1 to SA2 are exposed, the mask M is scanned. When the shot fields in even lines including the shot fields SA3 to SA6 are exposed, the mask M' is scanned. Therefore, the slit lights EL and EL' are changed over for every shot line. The changeover can be performed by stopping the light source of the slit light EL or EL' on the side not to be scanned, or by shading the optical path of the slit light EL or EL' on the side not to be scanned by blind control. When the light source is stopped, since time is required until the light source is stabilized after being restored, it is desired to change over the slit lights EL and EL' by the blind control. Moreover, the rotation of the polygon mirror 22 or 22' on the side not to be scanned can be suspended, however, since time is required for reaching a stable uniform speed rotation after being restored, it is preferred to continue the rotation operation.

The control apparatus 3 rotates the polygon mirror 22 in the counterclockwise direction, and also moves the reflecting mirror 33A in the -Y direction synchronously with the rotation of the polygon mirror 22, in a state with the slit light EL' shaded. The slit light EL having scanned the mask M is, as shown in FIG 16, reflected by the reflecting surface 33a of the reflecting mirror 33A and bent in the -Y direction, and then reflected by the reflecting surface 33b of the reflecting mirror 33E and bent in the +Z direction. The slit light EL reflected by the reflecting mirror 33E is sequentially reflected by the reflecting surfaces 43a and 43b of the reflecting mirror 43, the reflecting mirror 44, the reflecting surface of the reflecting mirror 50a, the reflecting mirror 50b, and the first reflecting system of the reflecting mirror 50, to enter into the projection optical system PL.

At this time, the reflecting mirror 43 of the correction optical system 40 moves in the Z axis direction, synchronously with the movement of the reflecting mirror 33A, to keep the optical path length of the slit light EL constant. This will be explained briefly. At the scanning start position, since the optical path between the reflecting mirrors 33A and 33E becomes longer than the optical path length when the slit light EL illuminates the center of the mask M as a reference, the reflecting mirror 43 is made to approach the reflecting mirror 44. On the contrary, at the scanning end position, since the optical path between the reflecting mirrors 33A and 33E becomes short, the reflecting mirror 43 is separated from the reflecting mirror 44. Thus, by bringing the reflecting mirror 43 close to or away from the reflecting mirror 44, synchronously with the movement of the reflecting mirror 33A, the slit light EL can enter into the projection optical system PL with a constant optical path length. Accordingly, the slit light EL enters into the projection optical system PL via the reflecting mirror 50 with a constant optical path length at all times, so that the pattern image of the mask M is sequentially projected onto the shot field SA1 on the substrate P shown in FIG. 4.

When the scanning exposure with respect to the shot field SA1 is finished, the reflecting mirror 33E is moved to the wait position T2 before the reflecting mirror 33A arrives, and the moved reflecting mirror 33A is positioned at the position where the reflecting mirror 33E has been positioned. Moreover the forefront reflecting mirror 33 (illustrated as reflecting mirror 33B) of the reflecting mirrors 33 positioned at the wait position T1 is moved to the scanning start position. The timing when the forefront reflecting mirror 33 is moved to the scanning start position may be such that it is not necessary to wait until the exposure to the shot field SA1 is finished, and the reflecting mirror 33 can be moved to the scanning start position immediately after the optical path of the slit light EL is away from the scanning start position.

When the scanning exposure to the shot field SA1 to be exposed first is finished, the movement of the substrate stage 2 in the -Y direction is continued without decelerating the substrate stage 2. Moreover, the mask M is scanned by the slit light EL reflected by the reflecting surface 22b of the polygon mirror 22 following reflection by the reflecting surface 22a, with respect to the shot field SA2, and the reflecting mirrors 33B and 43 are synchronously moved. Accordingly, the pattern image of the mask M is sequentially projected onto the shot field SA2 arranged on the +Y side of the shot field SA1 on the substrate P.

At the time of finishing the scan, the reflecting mirror 33A is also moved to the wait position T2 before the reflecting mirror 33B arrives.

When the exposure to the shot field SA2 is finished, the control apparatus 3 changes over the moving direction of the substrate stage 2 to the opposite direction, and steps the substrate stage 2 forward to a position where the pattern of the mask M' is projected into the shot field SA3. Moreover the control apparatus 3 positions the moved reflecting mirror 33B, as shown in FIG 17, at a position corresponding to the scanning start position Me with respect to the mask M', and arranges the reflecting mirror 33 positioned at the forefront of the wait position T1 (illustrated as reference sign 33C in FIG 17) at a position where the slit light EL' reflected by the reflecting mirror 33B is reflected toward the reflecting mirror 45 by the reflecting surface 33a.

Furthermore the control apparatus 3 rotates the polygon mirror 22' in the clockwise direction in a state with the slit light EL shaded and shading of the slit light EL' released by the blind control, and moves the reflecting mirror 33B in the +Y direction synchronously with the rotation of the polygon mirror 22'. The slit light EL' having scanned the mask M' is, as shown in FIG 17, reflected by the reflecting surface 33b of the reflecting mirror 33B and bent in the +Y direction, and then reflected by the reflecting surface 3 3 a of the reflecting mirror 33C and bent in the +Z direction. The slit light EL' reflected by the reflecting mirror 33C is sequentially reflected by the reflecting surfaces 45a and 45b of the reflecting mirror 45, the reflecting mirror 46, and the second reflecting system of the reflecting mirror 51 to enter into the projection optical system PL.

In the present embodiment, the illumination light for the mask M, that is, the reflection light from the reflecting mirror 50, and the illumination light for the mask M', that is, the reflection light from the reflecting mirror 51, are made to enter into positions slightly shifted from each other from the center of the projection optical system PL (optical axis) in the scanning direction (Y direction), so as to be imaged respectively on the substrate P.

In other embodiments, the reflection light from the reflecting mirror 50 and the reflection light from the reflecting mirror 51 can be changed over by a mirror to enter into the center of the projection optical system PL (optical axis), or the reflection light can be made to enter into the center of the projection optical system PL (optical axis) by using a polarized beam splitter or a half mirror as in FIG 7.

At this time, as in the case of the correction optical system 40, the reflecting mirror 45 of the correction optical system 40' moves in the Z axis direction, synchronously with the movement of the reflecting mirror 33B, to keep the optical path length of the slit light EL' constant. Accordingly, the slit light EL' enters into the projection optical system PL via the reflecting mirror 51 with a constant optical path length at all times, so that the pattern image of the mask M is sequentially projected into the shot field SA3 on the substrate P shown in FIG 4.

In the present embodiment, when the scanning exposure to the shot field SA3 is finished, the reflecting mirror 33C is moved to the wait position T1 before the reflecting mirror 33B arrives, and the moved reflecting mirror 33B is positioned at the position where the reflecting mirror 33C has been positioned. Moreover the reflecting mirror 33A positioned at the wait position T2 is moved to the scanning start position. Thereafter, the same operation as the exposure operation with respect to the shot field SA3 is repeated, thereby enabling to continuously expose the shot fields SA3 to SA6 in the second line at one scan.

In the present embodiment, the polygon mirrors 22 and 22' that scan the mask M and M' in the opposite scanning direction to each other are provided, and the slit lights EL and EL' guided to the substrate P are changed over according to the scanning direction. Accordingly, continuous and smooth exposure processing can be performed without suspending or changing the operation between the lines in the shot fields.

### <Eighth embodiment>

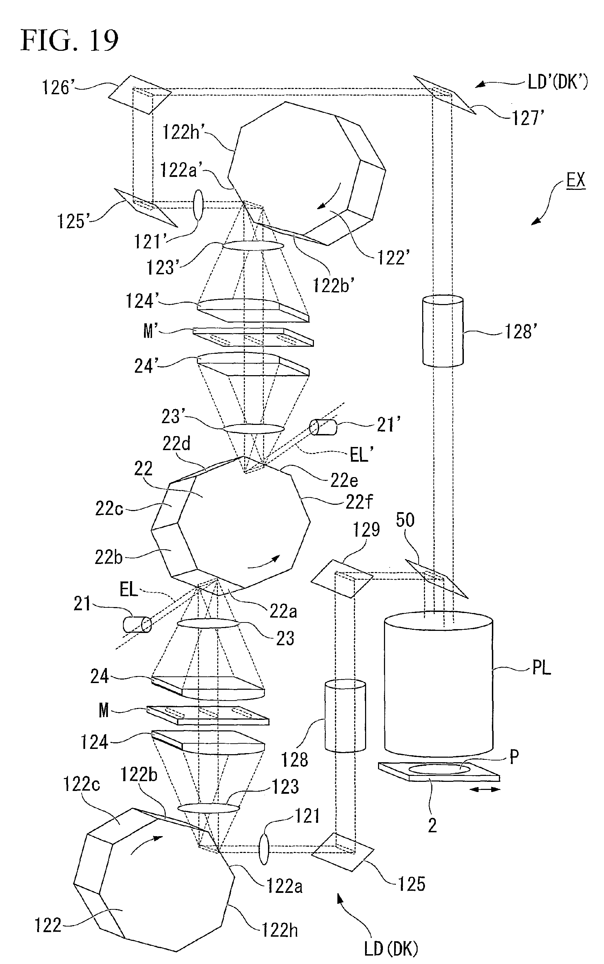

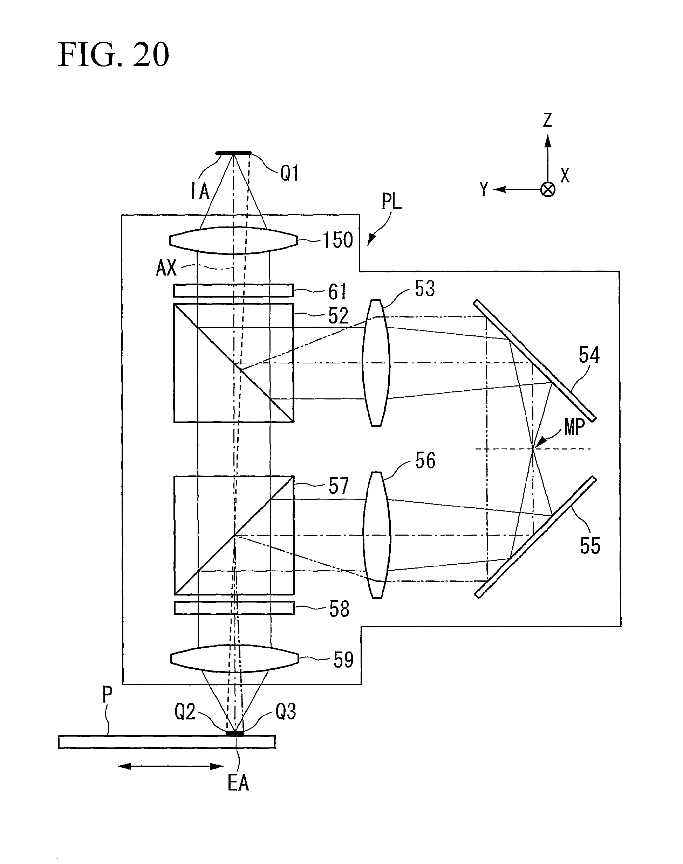

Next, an eighth embodiment of the present invention will be described with reference to FIGS. 19 and 20. In the present embodiment, a second optical guiding device DK' (conduction apparatus LD') is also provided as in the third embodiment shown in FIG 7, and polygon mirrors are respectively provided in each conduction apparatus as in the sixth embodiment shown in FIG 13. In the present embodiment, the configuration of the projection optical system PL is different from those in the third and the sixth embodiments.

The configuration will be described in detail. Components the same as or similar to the abovementioned embodiments shown in FIGS. 7 and 13 are denoted by the same reference symbols, and their description is omitted.

As shown in FIG 19, in a conduction apparatus LD in an exposure apparatus EX of the present embodiment, a reflecting mirror 125 that reflects and bends a slit light EL having scanned the mask M and been reflected in the -Y direction by a polygon mirror 122, to the +Z direction to enter into a relay lens 128, and a reflecting mirror 129 that reflects and bends the slit light EL that has passed through the relay lens 128, toward the reflecting mirror 50 are provided.

In the exposure apparatus EX of the present embodiment, the second optical guiding device DK' (conduction apparatus LD') that causes the slit light EL' reflected by a surface (reflecting surface (fourth reflecting surface) 22e in FIG 19) opposite to a surface (reflecting surface (third reflecting surface) 22a in FIG. 19) for reflecting the slit light EL of the polygon mirror 22 and having scanned the mask M' to enter into the projection optical system PL is provided. In the conduction apparatus LD', a polygon mirror (second polygon mirror) 122' that causes the slit light EL' having scanned the mask M' to enter into the projection optical system PL via a correcting lens 121', reflecting mirrors 125', 126' and 127', and the relay lens 128 are provided. An fθ lens 123' and a telecentric lens 124' having the same configuration as those of the fθ lens 123 and the telecentric lens 124 are arranged between the mask M' and the polygon mirror 122'. The polygon mirror 122' has a plurality of reflecting surfaces 122a' to 122h' (eight in FIG. 19) on the outer circumference thereof, and the rotation thereof is controlled by a control apparatus 3. These reflecting surfaces 122a' to 122h' are formed so as to have a surface including a position conjugate to the pattern field of the mask M'.

In the present embodiment, a pattern to be transferred onto the substrate P in an inverted image is formed on the mask M as shown in FIG 18B. A pattern to be transferred to the substrate P in an erect image is formed on the mask M', as shown as an image seen from a traveling direction of the slit light EL' in FIG. 18C.

FIG. 20 is a side view of the projection optical system PL. As shown in FIG 20, the projection optical system PL of the present embodiment includes a projection lens 150, a 1/2 wave plate 61, a polarized beam splitter 52, an erect image forming lens 53, bending mirrors 54 and 55, an erect image forming lens 56, a polarized beam splitter 57, a 1/2 wave plate 58, and a projection lens 59. An image switching device that switches the image to be projected on the substrate P between the inverted image and the erect image is constituted by these optical devices and the control apparatus 3.

In FIG. 20, a field shown by the thick line on the incident side of the projection optical system PL is an illumination field IA where the slit light EL is irradiated, and a field shown by the thick line on the substrate P is an exposure field EA where the slit light EL is irradiated.

The projection lens 150 converts the slit lights EL and EL' from the masks M and M' into parallel lights. The 1/2 wave plates 61 and 58 change the polarization direction of the incident lights, and are formed so as to be rotatable about an optical axis AX. The rotation amount of these 1/2 wave plates 61 and 58 is controlled by the control apparatus 3. Specifically, the control apparatus 3 controls the respective rotation amounts of the 1/2 wave plates 61 and 58 so that the 1/2 wave plate 58 rotates with the rotation of the 1/2 wave plate 61. The polarized beam splitters 52 and 57 transmit only the light with the polarization direction being in the Y axis direction, and reflect the light with the polarization direction being in the X axis direction. The erect image forming lens 53 forms an intermediate image at an intermediate projection point MP, and the erect image forming lens 56 converts the lights via the intermediate imaging point MP into parallel lights. The projection lens 59 focuses the lights transmitted through the 1/2 wave plate 58 onto a wafer W.

In the above configuration, the slit light from one point in the illumination field IA enters into the projection lens 150 and is converted into parallel light, and enters into the 1/2 wave plate 61. Since the slit lights EL and EL' pass through the 1/2 wave plate 61, the polarization direction of the slit lights EL and EL' becomes either the X direction or the Y direction. The slit lights EL and EL' having passed through the 1/2 wave plate 61 enter into the polarized beam splitter 52. Here when the polarization direction of the slit lights EL and EL' passing through the 1/2 wave plate 61 is in the Y direction, the slit lights EL and EL' transmit through the polarized beam splitter 52, and when the polarization direction of the slit lights EL and EL' is in the X direction, the slit lights EL and EL' are reflected by the polarized beam splitter 52.

The slit lights EL and EL' transmitted through the polarized beam splitter 52 reach the polarized beam splitter 57. As described above, since the polarized beam splitters 52 and 57 are arranged so that the polarization directions of the light to be transmitted are the same as each other, the slit lights EL and EL' entering from the polarized beam splitter 52 into the polarized beam splitter 57 transmit through the polarized beam splitter 57. When the slit lights EL and EL' having transmitted through the polarized beam splitter 57 pass through the 1/2 wave plate 58, the polarization direction thereof is returned to the direction before entering into the 1/2 wave plate 61, and the slit lights EL and EL' enter into the projection lens 59. The projection lens 59 refracts the slit lights EL and EL' emitted from one point on the illumination field IA and having passed through the respective optical devices in the projection optical system PL so as to be focused at one point of the exposure field EA on the substrate P.

On the other hand, the slit lights EL and EL' reflected by the polarized beam splitter 52 enter into the erect image forming lens 53, are refracted, and are bent by the bending mirror 54 to reach the intermediate imaging point MP. In the intermediate imaging point MP, an inverted image of the pattern in the illumination field IA is imaged. The slit lights EL and EL' having passed through the intermediate imaging point are bent by the bending mirror 55 to enter into the polarized beam splitter 57 via the erect image forming lens 56. Since the polarized beam splitters 52 and 57 are arranged so that the polarization directions of the lights to be reflected become the same as each other, the polarized beam splitter 57 reflects the slit lights EL and EL' from the erect image forming lens 56. When the slit lights EL and EL' reflected by the polarized beam splitter 57 pass through the 1/2 wave plate 58, the polarization direction thereof is returned to the direction before entering into the 1/2 wave plate 61, and the slit lights EL and EL' enter into the projection lens 59. The projection lens 59 refracts the slit lights EL and EL' emitted from one point on the illumination field IA and having passed through the respective optical devices in the projection optical system PL so as to be focused at one point of the exposure field EA on the substrate P.

Incidentally in FIG. 20, a principal ray of the slit lights EL and EL' from a point Q 1 in the illumination field IA on the +Y side is shown by a broken line or two-dot chain line. The routes of the slit lights EL and EL' are different according to whether the slit lights EL and EL' transmit through the polarized beam splitter 52 or are reflected by the polarized beam splitter 52. The principal ray when the slit lights EL and EL' transmit through the polarized beam splitter 52 is shown by a broken line, and the principal ray when the slit lights EL and EL' are reflected by the polarized beam splitter 52 is shown by the two-dot chain line. As shown in FIG 20, when the slit lights EL and EL' transmit through the polarized beam splitter 52, the principal ray of the slit lights EL and EL' from the point Q1 passes through a route shown by the broken line to reach a point Q2 in the exposure field EA. That is, in this case, the image of the point Q1 in the illumination field IA is imaged at the point Q2 in the exposure field EA. On the other hand, when the slit lights are reflected by the polarized beam splitter 52, the principal ray of the slit lights EL and EL' from the point Q1 passes through a route shown by the two-dot chain line to reach a point Q3 in the exposure field EA. That is, in this case, the image at the point Q1 in the illumination field IA is imaged at the point Q3 in the exposure field EA.

Considering the whole illumination field IA, when the slit lights EL and EL' pass through the polarized beam splitter 52, the inverted image of the pattern in the illumination field IA is imaged in the exposure field EA, and when the slit lights are reflected by the polarized beam splitter 52, the erect image of the pattern in the illumination field IA is imaged in the exposure field EA. That is, it is determined whether the pattern image in the illumination field IA is imaged in the inverted image or the erect image according to whether the slit lights EL and EL' transmit through or are reflected by the polarized beam splitter 52. Since the polarization direction of the slit lights EL and EL' in the projection optical system PL is determined according to the rotation amount of the 1/2 wave plate 61, the control apparatus 3 can adjust the rotation amount of the 1/2 wave plate 61, to control whether to project the inverted image or the erect image on the substrate P.

In the exposure apparatus EX having the aforementioned configuration, when the shot fields SA1 to SA2 in the first line on the substrate P shown in FIG 4 are to be exposed, the control apparatus 3 shades the slit light EL' by the blind control, and adjusts the rotation amount of the 1/2 wave plate 61 in the projection optical system PL to rotate the polygon mirror 22 in the counterclockwise direction in a state with the inverted image projected on the substrate P. Accordingly, the slit light EL reflected by the reflecting surface 22a of the polygon mirror 22 scans the mask M in the -Y direction synchronously with the rotation of the polygon mirror 22, to project the inverted image into the shot field SA1 on the substrate P. Then the control apparatus 3 continues to successively move the substrate stage 2 in the -Y direction, and scans the mask M with the slit light EL reflected by the reflecting surface 22b of the polygon mirror 22 to project the inverted image of the pattern into the shot field SA2 on the substrate P.

When the exposure to the shot field SA2 is finished, the control apparatus 3 changes over the moving direction of the substrate stage 2 to the opposite direction, and steps the substrate stage 2 forward to the position where the pattern of the mask M' is projected to the shot field SA3. Moreover the control apparatus 3 shades the slit light EL by the blind control, releases shading of the slit light EL', and changes the setting so that the rotation amount of the 1/2 wave plate 61 in the projection optical system PL is adjusted to project the erect image on the substrate P.

Accordingly, the slit light EL' reflected by the reflecting surface 22e of the polygon mirror 22 scans the mask M' in the +Y direction synchronously with the rotation of the polygon mirror 22 to project the erect image of the pattern into the shot field SA3 on the substrate P. Subsequently, the control apparatus 3 continues to move the substrate stage 2 in the +Y direction, and scans the mask M' with the slit light EL' reflected by the reflecting surface 22f of the polygon mirror 22 to project the erect image of the pattern into the shot field SA4 on the substrate P. The same operation as the exposure operation to the shot field SA4 is repeated thereafter, thereby enabling to continuously expose the shot fields SA3 to SA6 in the second line by one scan.

Thus, also in the present embodiment, continuous and smooth exposure processing can be performed with the rotation direction of the polygon mirror 22 being constant, without suspending or changing the operation between the lines of the shot fields.

### <Ninth embodiment>

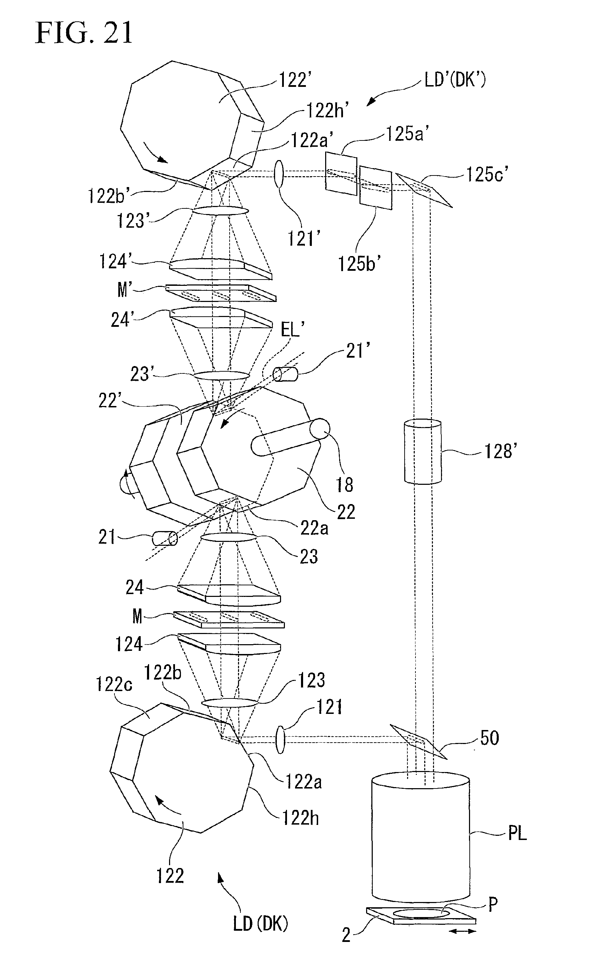

Next, a ninth embodiment of the present invention will be described with reference to FIG. 21.

In the present embodiment, with respect to the eighth embodiment shown in FIGS. 19 and 20, polygon mirrors for scanning masks M and M' by slit lights EL and EL' are separately provided. This configuration will be described in detail. Components the same as or similar to the abovementioned eighth embodiment shown in FIGS. 19 and 20 are denoted by the same reference symbols, and their description is omitted.

As shown in FIG. 21, in the present embodiment, a polygon mirror 22 serving as a scanning device and a polygon mirror 22' serving as a second scanning device are supported by a spindle 18, and rotate in the opposite direction to each other about the X axis. In the figure, the slit light EL reflected by the polygon mirror 22 rotating in the counterclockwise direction, substantially in the -Z direction scans the mask M in the -Y direction accompanying the rotation of the polygon mirror 22, and is reflected by a polygon mirror 122 that forms a conduction apparatus LD and rotates synchronously with the scan, to enter into the projection optical system PL via a reflecting mirror 50.

On the other hand, the slit light EL' reflected by the polygon mirror 22' rotating in the clockwise direction, substantially in the +Z direction scans the mask M' accompanying the rotation of the polygon mirror 22' in the -Y direction as with the slit light EL, and is reflected by a polygon mirror 122' that forms a conduction apparatus LD' and rotates synchronously with the scan, to enter into the projection optical system PL via reflecting mirrors 125a', 125b', and 125c', and a relay lens 128'.

In the present embodiment, the illumination light for the mask M, that is, the reflecting light from the reflecting mirror 50, and the illumination light for the mask M', that is, the reflecting light from the reflecting mirror 125c' are made to enter into positions slightly shifted from each other from the center of the projection optical system PL (optical axis) in the scanning direction (Y direction), so as to be imaged respectively on the substrate P.

In other embodiments, the reflection light from the reflecting mirror 50 and the reflection light from the reflecting mirror 125c' can be changed over by a mirror to enter into the center of the projection optical system PL (optical axis), or the reflection light can be made to enter into the center of the projection optical system PL (optical axis) by using a polarized beam splitter or a half mirror as in FIG. 7.

In the present embodiment, a pattern to be transferred onto the substrate P in an inverted image is formed on the mask M as shown in FIG. 18B. Moreover, a pattern to be transferred onto the substrate P in an erect image is formed on the mask M', as shown as an image seen from the traveling direction of the slit light EL' in FIG 18D, so that the respective patterns face directions different to each other by 180 degrees with respect to the mask M. In the present embodiment, the projection optical system PL that projects the inverted image to the substrate P is used.

In the exposure apparatus EX, when the shot fields SA1 to SA2 in the first line on the substrate P shown in FIG. 4 are to be exposed, the control apparatus 3 scans the mask M in a state with the slit light EL' shaded and shading of the slit light EL released by the blind control. Accordingly, the slit light EL reflected by the reflecting surface 22a of the polygon mirror 22 scans the mask M in the -Y direction synchronously with the rotation of the polygon mirror 22, to project the inverted image into the shot field SA1 on the substrate P. The control apparatus 3 continues to successively move the substrate stage 2 in the -Y direction, and scans the mask M with the slit light EL reflected by the reflecting surface 22b of the polygon mirror 22 to project the inverted image pattern into the shot field SA2 on the substrate P.

On the other hand, when the exposure to the shot field SA2 is finished and exposure to the shot fields SA3 to SA6 in the second line is performed, the control apparatus 3 changes over the moving direction of the substrate stage 2 to the opposite direction, and steps the substrate stage 2 forward to the position where the pattern of the mask M' is projected into the shot field SA3. The control apparatus 3 also shades the slit light EL by the blind control, and releases shading of the slit light EL'. Accordingly, the slit light EL' reflected by the reflecting surface 22a' of the polygon mirror 22' (not shown in FIG 21) scans the mask M in the -Y direction, synchronously with the rotation of the polygon mirror 22, and is reflected by the polygon mirror 122' to enter into the projection optical system PL, to thereby project the inverted image pattern into the shot field SA3 on the substrate P. The same operation as the exposure operation to the shot field SA4 is repeated thereafter, thereby enabling to continuously expose the shot fields SA3 to SA6 in the second line by one scan.

Thus, also in the present embodiment, continuous and smooth exposure processing can be performed with the rotation direction of the polygon mirrors 22 and 22' being constant, without suspending or changing the operation between the lines of the shot fields.

In the ninth embodiment, substantially the same patterns are arranged on the masks M and M'. However, the embodiment is not limited thereto. For example, different patterns can be arranged so as to perform simultaneous double exposure (multiple exposure) as explained in the third embodiment.

In this case, the polygon mirrors 22 and 22' and the polygon mirrors 122 and 122' that rotate in the opposite direction to each other in the ninth embodiment are respectively rotated in the same direction, thereby enabling to perform the simultaneous double exposure (multiple exposure) on the substrate P in the same direction. At this time, the rotation direction of the polygon mirrors 22 and 22' is opposite to that of the polygon mirrors 122 and 122'.

Accordingly, in the exposure apparatus EX shown in FIG 21, one of the polygon mirrors 22 and 22' (and polygon mirrors 122 and 122') is rotated in a certain direction, and by changing over the rotation direction of the other polygon mirror, the continuous exposure between lines of the shot fields, which does not reverse the rotation of the polygon mirrors 22 and 22' as the scanning devices, and the simultaneous double exposure can be easily changed over and selected.

The preferred embodiments according to the present invention have been explained with reference to the accompanying drawings, but the present invention is not limited to those examples. Various shapes and combinations of respective components shown in the aforementioned examples are examples only, and can be variously changed based on design requirement, without departing from the spirit and scope of the present invention.

For example, the continuous exposure between lines of the shot fields, which does not reverse the rotation of the polygon mirror as the scanning device, can be also realized in the exposure apparatus EX in the first to the sixth embodiments. In this case, the first pattern as shown in FIG. 18B and a second pattern, which is point symmetry to the first pattern (facing a different direction by 180 degrees), as shown in FIG. 18D are arranged on the mask M away from each other in a non-scanning direction (the X axis direction) (in the case of the third embodiment shown in FIG. 7, the second pattern is arranged on the mask M'), and the image switching device shown in FIG. 20 is provided in the projection optical system PL.

The first pattern is then exposed in the shot fields in the first line in an inverted image, and the second pattern is exposed in the shot fields in the second line in an erect image by the blind control. Switching of the inverted image and the erect image is performed under control of the control apparatus 3. Accordingly, the continuous exposure between lines of the shot fields, which does not include the reverse rotation of the polygon mirror, can be realized.

In the aforementioned embodiments, the polygon mirror is used as the optical element that scans the slit light. However, the embodiments are not limited thereto, and for example, the reflecting mirror can be rocked. In the aforementioned embodiments, simultaneous double exposure is explained as an example of multiple exposure. However, a configuration where three or more patterns are exposed can be used.

As the substrate P in the abovementioned respective embodiments, not only a semiconductor wafer for manufacturing a semiconductor device, but also a glass substrate for a display device, a ceramic wafer for a thin-film magnetic head, an original plate of a mask or a reticle (synthetic quarts or silicon wafer) used in an exposure apparatus, or film members can be used. The shape of the substrate is not limited to a circle, and may be another shape such as a rectangle.

The exposure apparatus EX can be applied to a step and repeat type projection exposure apparatus (stepper) that exposes the pattern of the mask M by one shot in a state with the mask M and the substrate P being stationary, and sequentially steps the substrate P forward, as well as to a step and scan type scanning exposure apparatus (scanning stepper) that synchronously moves the mask M and the substrate P to scan and expose the pattern of the mask M. Moreover, the present invention is also applicable to a step and switch type exposure apparatus that partially overlaps and transfers at least two patterns onto the substrate P.

The types of the exposure apparatus EX are not limited to the exposure apparatuses for the manufacture of semiconductor devices that expose a semiconductor device pattern onto a substrate P, but are also widely applicable to exposure apparatuses for the manufacture of liquid crystal display devices and for the manufacture of displays, and exposure apparatuses for the manufacture of thin-film magnetic heads, image pickup devices (CCDs), micro machines, MEMS, DNA chips, and reticles or masks.

For the light source of the exposure apparatus to which the present invention is applied, not only a KrF excimer laser (248 nm), an ArF excimer laser (193 nm), or an F₂ laser (157 nm), but also g-ray (436 nm) and i-ray (365 nm) can be used. The magnification of the projection optical system may involve not only a reduction system but may also involve an equal magnification or an enlarging system. In the aforementioned embodiments, a catadioptric projection optical system is shown. However, the present invention is not limited thereto, and is also applicable to a refractive projection optical system in which an optical axis of the projection optical system (center of the reticle) and the center of the projection field are set to different positions.

In other embodiments, an electronic mask for generating a variable pattern (also referred to as a variable shaped mask, active mask, or pattern generator) can be used. As the electronic mask, for example, a deformable micro-mirror device or digital micro-mirror device (DMD), which is a kind of a non-emitting type image display element (also referred to as a spatial light modulator (SLM)) can be used. The DMD has a plurality of reflecting elements (micro-mirrors) driven based on predetermined electronic data, and the plurality of reflecting elements are arranged in a two-dimensional matrix on the surface of the DMD and driven in element units, to reflect and deflect the exposure light. The angle of reflecting surfaces of the respective reflecting elements is adjusted. Operation of the DMD can be controlled by a control apparatus. The control apparatus drives the reflecting elements of the respective DMDs based on the electronic data (pattern information) corresponding to the pattern to be formed on the substrate, and patterns the exposure light irradiated by an illumination system by the reflecting elements. By using the DMD, a replacement operation of the mask and a positioning operation of the mask on the mask stage are not required when the pattern is changed, as compared to a case in which exposure is performed by using a mask (reticle) having a pattern formed thereon. In the exposure apparatus using the electronic mask, the mask stage may not be provided, and the substrate may be moved in the X axis and Y axis directions by the substrate stage. Moreover, in order to adjust the relative position of pattern images on the substrate, the relative position of the electronic masks that respectively generate a pattern may be adjusted by, for example, an actuator. The exposure apparatus using the DMD is disclosed for example in Japanese Patent Application Publication Nos. H 8-313842 A and 2004-304135 A, and U.S. Patent No. 6,778, 257.

The present invention is also applicable to a so-called liquid immersion exposure apparatus in which a liquid is locally filled between a projection optical system and a substrate and the substrate is exposed via the liquid. The liquid immersion exposure apparatus is disclosed in PCT International Patent Publication No. WO1999/49504 and Japanese Patent Application Publication No 2004-289126 A (and corresponding U.S. Patent Application No. 2004/0165159). The present invention is also applicable to a liquid immersion exposure apparatus that performs exposure in a state with an entire surface of a substrate to be exposed is immersed in the liquid, as disclosed in Japanese Patent Application Publication Nos. H06-124873 A and H10-303114 A, and U. S. Patent No. 5,825,043. The liquid immersion system is provided, for example, near an optical path of the exposure light between a terminal optical element of the projection optical system and the substrate, and can include a supply member having a supply port for supplying the liquid to the optical path and a collection member having a collection port for collecting the liquid. The liquid immersion system need not be provided partially in the exposure apparatus (for example, the liquid supply member and/or the liquid collection member), and for example, can use equipment such as a factory where the exposure apparatus is installed. Moreover the structure of the liquid immersion system is not limited to the aforementioned structure, and for example, ones described in European Patent Publication No. 1420298, PCT International Patent Publication No. WO2004/055803, PCT International Patent Publication No. WO2004/057590, PCT International Patent Publication No. WO2005/029559 (corresponding U.S. Patent Application Publication No. 2006/0231206), PCT International Patent Publication No. WO2004/086468 (corresponding U. S. Patent Application Publication No. 2005/028791), and Japanese Patent Application Publication No 2004-289126 A (corresponding U. S. Patent No. 6,952,253) can be used.

As the liquid to be used in a liquid immersion method, water (pure water) can be used, or other than water, for example, a fluorinated fluid such as perfluoro polyether (PFPE) or a fluorine oil, or a cedar oil or the like may be used. Moreover as the liquid, a liquid with a refractive index that is higher than that of water with respect to the exposure light, for example a liquid with a refractive index of approximately 1.6 to 1.8 may be used. Here, as a liquid LQ having a higher refractive index than that of pure water (for example, 1.5 or higher), there can be mentioned, for example, a predetermined liquid having a C-H bond or an O-H bond such as isopropanol with a refractive index of approximately 1.50 and glycerol (glycerin) with a refractive index of approximately 1.61, a predetermined liquid such as hexane, heptane, and decane (organic solvent), or Decalin (Decahydronaphthalene) with a refractive index of approximately 1.60. Alternatively, the liquid LQ may be a liquid where two or more types of optional liquids are mixed, or a liquid where a predetermined liquid may is added to (mixed with) pure water. Alternatively, as the liquid LQ, one in which a base or an acid such as H⁺, Cs⁺, and K⁺, or Cl⁻, SO₄²⁻, and PO₄²⁻ is added to (mixed with) pure water may be used. Moreover, a liquid in which fine particles of for example Al oxide are added to (mixed with) pure water may be used. As the liquid, the liquid is preferably one for which the light absorption coefficient is small, the temperature dependency is small, and which is stable with respect to the photosensitive material (or top coat film or anti-reflection film) painted on the surface of the projection optical system and/or the surface of the substrate. A supercritical fluid can be used for the liquid. Moreover, a top coat film that protects the photosensitive material and a base material from the liquid can be provided on the substrate. Furthermore, the terminal optical element can be formed from quartz (silica), or a single crystal material of fluorine compounds such as calcium fluoride (fluorite), barium fluoride, strontium fluoride, lithium fluoride, and sodium fluoride, or can be formed from a material with a higher refractive index than that of quartz and fluorite (for example 1.6 or higher). As the material with the refractive index of 1.6 or higher, for example, sapphire and germanium dioxide disclosed in PCT International Patent Publication No. WO2005/059617, or potassium chloride (refractive index is about 1.75) disclosed PCT International Patent Publication No. WO2005/059618 can be used.

When the liquid immersion method is used, as disclosed for example in PCT International Patent Publication No. W02004/019128 (corresponding U.S. Patent Application Publication No. 2005/0248856), in addition to the optical path on an image plane side of the terminal optical element, the optical path on an object surface side of the terminal optical element can be filled with the liquid. Moreover, a thin film having a lyophilic property and/or a dissolution-preventing function may be formed on a part (including at least a contact face with the liquid) or whole of the surface of the terminal optical element. Quartz has a high compatibility with the liquid, and a dissolution-preventing film is not required; however, it is preferable to form the dissolution-preventing film in the case of fluorite.

The above respective embodiments are ones which measure the position information of the mask stage and the substrate stage using an interferometer system. However the invention is not limited to this, and for example an encoder system that detects a scale (grating) provided for example on the top surface of the substrate stage may be used. In this case, as a hybrid system which uses both the interferometer system and the encoder system, preferably the measurement results of the interferometer system are used to perform calibration on the detection results of the encoder system. Furthermore, the interferometer system and the encoder system may be alternately used, or both may be used, to perform position control of the substrate stage.

The present invention is also applicable to a twin-stage type exposure apparatus in which a plurality of substrate stages (wafer stages) is provided. The structure and the exposure operation of the twin-stage type exposure apparatus are disclosed for example in Japanese Patent Application Publication Nos. H10-163099 A and H10-214783 A (corresponding U.S. Patent Nos. 6,341,007, 6,400,441, 6,549,269, and 6,590,634), Published Japanese translation No. 2000-505958 of PCT International Publication (corresponding U.S. Patent No 5,969,441) or U.S. Patent No. 6,208,407. Moreover, the present invention can be applied to a wafer stage described in Japanese Patent Application No. 2004-168481 filed previously by the present applicant.

As far as is permitted by law, the disclosures in all of the Patent Publications and U.S. Patents related to exposure apparatuses and the like cited in the above respective embodiments and modified examples, are incorporated herein by reference.

As described above, the exposure apparatus of the aforementioned embodiments is manufactured by assembling various subsystems, including the respective constituent elements, so that prescribed mechanical, electrical, and optical accuracies are maintained. To ensure these various accuracies, adjustments are performed before and after this assembly, including an adjustment to achieve optical accuracy for the various optical systems, an adjustment to achieve mechanical accuracy for the various mechanical systems, and an adjustment to achieve electrical accuracy for the various electrical systems. The process of assembling the exposure apparatus from the various subsystems includes, for example, the mutual mechanical connection, the wiring and connection of electrical circuits, and the piping and connection of the atmospheric pressure circuit of the various subsystems. Of course, before the process of assembling the exposure apparatus from these various subsystems, there are also the processes of assembling each individual subsystem. When the process of assembling the exposure apparatus from the various subsystems is finished, a comprehensive adjustment is performed to ensure the various accuracies of the exposure apparatus as a whole. Furthermore, it is preferable to manufacture the exposure apparatus in a clean room wherein, for example, the temperature and the cleanliness level are controlled.

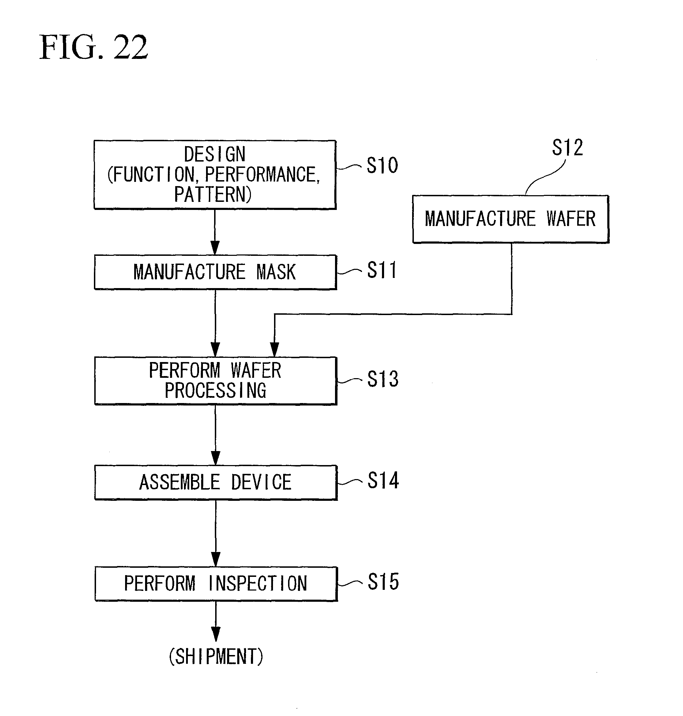

An embodiment of a manufacturing method for microdevices in which the exposure apparatus and the exposure method according to the embodiments of the present invention are used in the lithography process will be explained next. FIG 22 is a flow chart showing one example of a process for fabricating microdevices (semiconductor chips such as ICs and LSIs, liquid crystal panels, CCDs, thin-film magnetic heads, micro-machines, and the like).

At first, in step S10 (design step), function and performance design of microdevices (for example, circuit design and the like of the semiconductor devices) is performed, and pattern design is performed to realize the function. Subsequently, in step S11 (mask manufacturing step), a mask (reticle) having the designed circuit pattern formed thereon is fabricated. On the other hand, in step S 12 (wafer manufacturing step), a wafer is fabricated by using a material such as silicon.

Subsequently, in step S 13 (wafer processing step), the mask and the wafer prepared in steps S10 to S 12 are used, to form an actual circuit and the like on the wafer by means of a lithography technique or the like. Then in step S 14 (device assembly step), the device is assembled by using the wafer processed in step S 13. The device assembly step includes a dicing process, a bonding process, and a packaging process (chip encapsulation) as required. Lastly, in step S15 (inspection step), operational checks and durability test of the microdevices manufactured in step S 14 are performed. After going through the above processes the microdevices are complete, and they are then shipped.

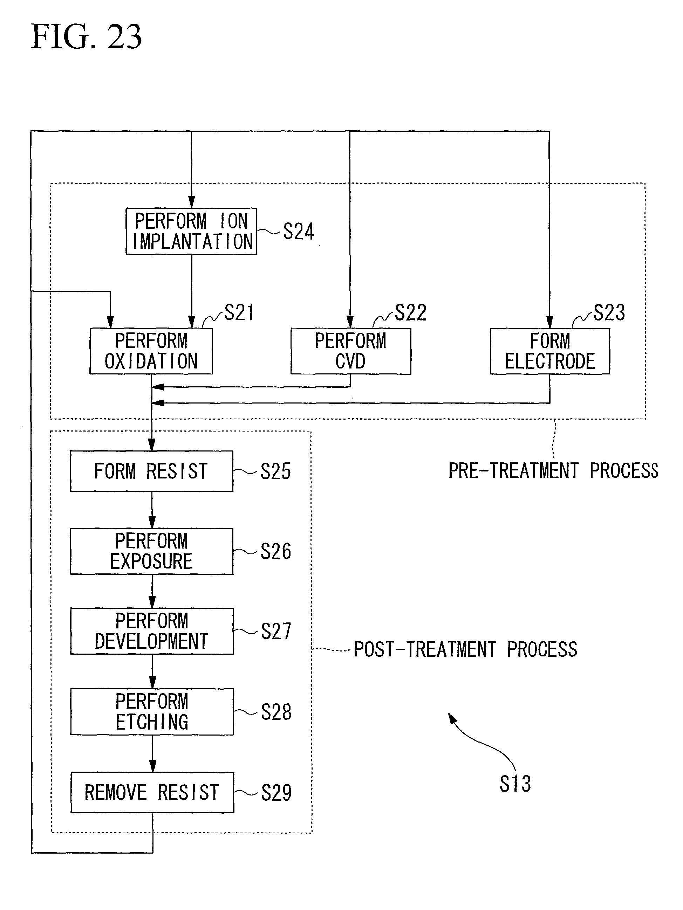

FIG. 23 shows one example of a detailed process in step S 13 in the case of manufacturing semiconductor devices.

In step S21 (oxidation step), the surface of the wafer is oxidized. In step S22 (CVD step), an insulating film is formed on the surface of the wafer. In step S23 (electrode forming step), an electrode is formed on the wafer by vapor deposition. In step S24 (ion implantation step), ions are implanted on the wafer. Each of the above steps S21 to S24 constitutes a pre-treatment process of each stage of wafer processing, and is selected and executed according to the process required in each stage.

In each stage of the wafer processing, when the aforementioned pre-treatment process is finished, a post-treatment process is executed in a following manner. In the post-treatment process, at first in step S25 (resist forming step), a photosensitizer is applied to the wafer. Subsequently, in step S26 (exposure step), a circuit pattern of the mask is transferred onto the wafer by the aforementioned lithography system (exposure apparatus) and the exposure method. In the next step S27 (development step), the exposed wafer is developed. In step S28 (etching step), an exposed member in a portion other than a portion where the resist remains, is removed by etching. In step S29 (resist removing step), the resist, which becomes unnecessary after completion of etching, is removed. By repeating these pre-treatment process and post-treatment process, multiple circuit patterns are formed on the wafer.

The present invention is also applicable to an exposure apparatus that transfers a circuit pattern from a mother reticle onto a glass substrate, a silicon wafer or the like in order to manufacture the reticle and the mask used in not only the microdevices such as semiconductor devices, but also in an optical exposure apparatus, an EUV exposure apparatus, an X-ray exposure apparatus, and an electron beam exposure apparatus. Here, in an exposure apparatus using deep ultraviolet beams (DUV), vacuum ultraviolet beams (VUV) or the like, a transmissive reticle is generally used, and as a reticle substrate, quartz glass, fluorine-doped quartz glass, fluorite, magnesium fluoride, crystal or the like is used. Moreover, in a proximity type X-ray exposure apparatus, or electron beam exposure apparatus, or the like, a transmissive mask (stencil mask, membrane mask) is used, and as the mask substrate, a silicon wafer or the like is used. These exposure apparatuses are disclosed in WO99/34255, WO99/50712, WO99/66370, Japanese Patent Application Publication No. H11-194479 A, Japanese Patent Application Publication No. 2000-12453 A, and Japanese Patent Application Publication No. 2000-29202 A.

## Claims

1. An exposure apparatus that illuminates a pattern on a first object with an illuminating beam to expose an area to be exposed on a second object with a pattern image, the exposure apparatus comprising:
a scanning apparatus that scans the first object along a prescribed scanning direction with the illuminating beam, and
an optical guiding device that guides the illuminating beam which has scanned the first object onto the area to be exposed on the second object.

2. An exposure apparatus that illuminates a pattern formed on a first object with an illuminating beam to expose an area to be exposed on a second object with the pattern image, the exposure apparatus comprising:
a scanning apparatus that scans the first object with the illuminating beam, and
a stage device capable of placing a second object thereon, which moves the second object synchronously with the scan of the first object with the illuminating beam.

3. An exposure apparatus that illuminates a pattern formed on a first object with an illuminating beam to expose an area to be exposed on a second object with a pattern image, the exposure apparatus comprising:
a scanning apparatus that scans the first object in a prescribed scanning direction with the illuminating beam;
an optical guiding device that guides the illuminating beam that has scanned the first object onto the second object; and
a stage device capable of placing a second object thereon, which moves the second object synchronously with the scan of the first object with the illuminating beam.

4. An exposure apparatus according to claim 2 or 3, wherein
the stage device moves the second object in an opposite direction to the scanning direction of the first object with the illumination beam.

5. An exposure apparatus according to claim 1 or 3, wherein the optical guiding device has; a projection optical system into which the illumination beam is entered and via which an image of the pattern is projected onto the area to be exposed, and a conduction apparatus that reflects the illumination beam that has scanned the first object and causes the illumination beam to enter into the projection optical system.

6. An exposure apparatus according to claim 4, wherein the conduction apparatus has a movable reflecting member that moves synchronously with the scanning of the illumination beam with respect to the first object.

7. An exposure apparatus according to claim 6, comprising a direction switching device that switches a moving direction of the movable reflecting member depending on a scanning direction of the illumination beam.

8. An exposure apparatus according to claim 7, wherein
the movable reflecting member has a first reflecting surface that reflects the illumination beam that has scanned the first object to one side of the moving direction, and a second reflecting surface that reflects the illumination beam to an other side of the moving direction,
and the conduction apparatus has a first reflecting system that causes the illumination beam that has been reflected by the first reflecting surface to enter into the projection optical system, and a second reflecting system that causes the illumination beam that has been reflected by the second reflecting surface to enter into the projection optical system.

9. An exposure apparatus according to any one of claims 6 to 8, wherein
a plurality of the areas to be exposed are provided along a scanning direction of the illumination beam, and
the movable reflecting member is provided so as to respectively correspond to the plurality of areas to be exposed.

10. An exposure apparatus according to any one of claims 5 to 9, wherein
the first object has a first pattern and a second pattern arranged in point symmetry to the first pattern,
and the projection optical system has an image switching device that switches an image to be projected on the area to be exposed between an inverted image and an erect image, depending on the first pattern or the second pattern.

11. An exposure apparatus according to claim 5, wherein the conduction apparatus has a concentrating device that concentrates the illuminating beam that has scanned the first object onto a predetermined position.

12. An exposure apparatus according to claim 11, wherein
the concentrating device has
a pair of displacement members that move in an optical axis direction of the illumination beam, and displace an optical path of the incident illumination beam by a displacement amount corresponding to a relative position relationship therebetween, and
an adjustment device that adjusts the relative position relationship of the pair of displacement members, according to a position of the illumination beam that has scanned the first object.

13. An exposure apparatus according to claim 12, wherein
the pair of displacement members have a first field and a second field in which the displacement directions of the optical path of the illumination beam are different,
and the adjustment device concentrates the optical path of the illumination beam that has been displaced in the first field to a first position, and concentrates the optical path of the illumination beam that has been displaced in the second field to a second position,
and the conduction apparatus has a second movable reflecting member that moves between the first position and the second position, and reflects the concentrated illumination beam towards the projection optical system.

14. An exposure apparatus according to any one of claims 1 to 13, wherein, the scanning apparatus has a polygon mirror.

15. An exposure apparatus according to claim 5, wherein the conduction apparatus has a second polygon mirror that rotates synchronously with the scanning of the illumination beam with respect to the first object.

16. An exposure apparatus according to any one of claims 1 to 15, comprising:
a second scanning apparatus that scans a second illumination beam that is different to a first illumination beam that illuminates the first object, in an opposite direction to a scanning direction of the first illumination beam, on a third object that is independent to the first object, the third object provided with a pattern to be transferred onto the second object, and
a second optical guiding device that guides the second illumination beam that has scanned the third object, onto the area to be exposed,
wherein the exposure apparatus switches between the first illumination beam and the second illumination beam as illumination beams that are guided onto the second object, in accordance with changes in a movement direction of the second object.

17. An exposure apparatus according to claim 16, comprising:
a polygon mirror having a third reflecting surface that reflects the illumination beam in the scanning apparatus, and a fourth reflecting surface that reflects the second illumination beam in the second scanning apparatus.

18. An exposure apparatus according to any one of claims 1 to 15, comprising:
a second scanning apparatus that scans a second illumination beam that is different to a first illumination beam that illuminates the first object, on a third object that is independent to the first object, the third object having a pattern to be transferred onto the second object, and
a second optical guiding device that guides the second illumination beam that has scanned the third object, onto the area to be exposed,
wherein the second illumination beam that has scanned the third object is guided together with the first illumination beam that has scanned the first object onto the area to be exposed on the second object.

19. An exposure apparatus according to claim 18, wherein
the first object and the third object are arranged so that their patterns face the same direction,
and the second scanning apparatus synchronously scans the second illumination beam in the same direction as the direction that the scanning apparatus scans the first object with the first illumination beam.

20. An exposure apparatus according to claim 18, wherein
the first object and the third object are arranged so that their patterns face directions different from each other by 180 degrees,
and the second scanning apparatus synchronously scans the third object with the second illumination beam in an opposite direction to the direction that the scanning apparatus scans the first object with the first illumination beam.

21. An exposure apparatus according to claim 20, wherein
the scanning apparatus, the second scanning apparatus, the optical guiding device, and the second optical guiding device are each provided with a polygon mirror,
and the polygon mirrors of each scanning apparatus rotates in the same direction,
and the polygon mirrors of the optical guiding devices rotate in the same direction as each other, and rotate in an opposite direction to the polygon mirrors of the scanning apparatuses.

22. An exposure apparatus according to any one of claims 1 to 21, comprising:
a compensator that corrects differences of an optical path length of the illumination beam that scans the first object and illuminates the area to be exposed.

23. An exposure method for illuminating a pattern on a first object with an illuminating beam to expose an area to be exposed on a second object with the pattern image, the exposure method comprising:
scanning the first object in a prescribed scanning direction with the illuminating beam, and
guiding the illuminating beam which has scanned the first object onto the area to be exposed on the second object.

24. An exposure method for illuminating a pattern formed on a first object with an illuminating beam to expose an area to be exposed on a second object with the pattern image, the exposure method comprising:
scanning the first object with the illuminating beam, and
moving a stage device capable of placing a second object thereon, synchronously with the scan of the first object with the illuminating beam.

25. An exposure method for illuminating a pattern formed on a first object with an illuminating beam to expose an area to be exposed on a second object with a pattern image, the exposure method comprising:
scanning the first object in a prescribed scanning direction with the illuminating beam;
guiding the illuminating beam that has scanned the first object onto the second object; and
moving a stage device capable of placing a second object thereon, synchronously with the scan of the first object with the illuminating beam.

26. An exposure method according to claim 24 or 25, wherein
the movement of the stage device comprises moving the second object in an opposite direction to the scanning direction of the first object with the illumination beam.

27. An exposure method according to claim 23 or 25, wherein
the optical guidance of the illumination beam comprises moving an optical path of the illumination beam that has scanned the first object, synchronized with a scan of the illumination beam, and causing an image of the pattern to enter into a projection optical system that projects onto the area to be exposed.

28. An exposure method according to claim 27, comprising:
switching a moving direction of an optical path of the illumination beam depending on a scanning direction of the illumination beam.

29. An exposure method according to claim 28, wherein
the illumination beam that has scanned the first object is reflected to one side or an other side in a moving direction of an optical path of the illumination beam depending on a scanning direction of the illumination beam.

30. An exposure method according to any one of claims 27 to 29, wherein
the first object has a first pattern and a second pattern arranged in point symmetry to the first pattern,
and the exposure method comprises switching an image that the projection optical system is to project onto the area to be exposed, between an inverted image and an erect image, depending on scanning of the first pattern or scanning of the second pattern.

31. An exposure method according to any one of claims 27 to 3 0, comprising:
concentrating the illuminating beam that has scanned the first object, onto a predetermined position.

32. An exposure method according to claim 31, comprising:
moving at least one of a pair of displacement members in an optical axis direction of the illumination beam, to displace an optical path of the incident illumination beam by a displacement amount according to a relative position relationship therebetween.

33. An exposure method according to claim 32, wherein
the pair of displacement members have a first field and a second field in which the displacement directions of the optical path of the illumination beam are different,
and the exposure method comprises:
concentrating the optical path of the illumination beam that has been displaced in the first field to a first position,
concentrating the optical path of the illumination beam that has been displaced in the second field to a second position, and
when a crossing portion of the first field and the second field is included in the optical path of the illumination beam, concentrating the optical path of the illumination beam to a third position between the first position and the second position.

34. An exposure apparatus according to any one of claims 23 to 33, wherein
the scanning of the illumination beam comprises rotating a polygon mirror.

35. An exposure method according to any one of claims 23 to 34 comprising:
scanning a second illumination beam that is different to a first illumination beam that illuminates the first object, in an opposite direction to a scanning direction of the first illumination beam, on a third object that is independent to the first object, the third object having a pattern to be transferred onto the second object;
guiding the second illumination beam that has scanned the third object, onto the area to be exposed; and
switching between the first illumination beam and the second illumination beam as illumination beams that are guided onto the second object, in accordance with changes in a scanning direction of the second object.

36. An exposure method according to claim 35, wherein the first illumination beam and the second illumination beam are reflected by reflection surfaces of a polygon mirror that are different to each other.

37. An exposure method according to any one of claims 23 to 34 comprising:
scanning a second illumination beam that is different to a first illumination beam that illuminates the first object, on a third object that is independent to the first object, the third object having a pattern to be transferred onto the second object;
guiding the second illumination beam that has scanned the third object, onto the area to be exposed; and
guiding the second illumination beam that has scanned the third object together with the first illumination beam that has scanned the first object onto the area to be exposed on the second object.

38. An exposure method according to claim 37, wherein
the first object and the third object are arranged so that their patterns face the same direction,
and the scanning of the second illumination beam comprises synchronously scanning the second illumination beam in the same direction as the direction that the first object is scanned with the first illumination beam.

39. An exposure method according to claim 37, wherein
the first object and the third object are arranged so that their patterns face directions different from each other by 180 degrees,
and the scanning of the second illumination beam comprises synchronously scanning the second illumination beam in an opposite direction to the direction that the first object is scanned with the first illumination beam.

40. An exposure method according to claim 39, wherein
the scanning of the first illumination beam, the scanning of the second illumination beam, the optical guiding of the first illumination beam, and the optical guiding of the second illumination beam, each use a polygon mirror, and
in the scanning of the first and second illumination beams, the polygon mirrors rotate in the same direction,
in the optical guiding of the first and second illumination beams, the polygon mirrors rotate in the same direction as each other, and rotate in an opposite direction to the polygon mirrors in the scanning step.

41. An exposure method according to any one of claims 23 to 40 comprising
correcting differences of an optical path length of the illumination beam that scans the first object and illuminates the area to be exposed.
